(19) **Europäisches Patentamt**
**European Patent Office**
**Office européen des brevets**

(11) **EP 4 782 475 A1**

(12) **EUROPEAN PATENT APPLICATION**
published in accordance with Art. 153(4) EPC

(43) Date of publication:
**29.07.2026 Bulletin 2026/31**

(21) Application number: **24868248.6**

(22) Date of filing: **17.09.2024**

(51) International Patent Classification (IPC):
**C08G 59/40** *(2006.01)*   **C08L 63/00** *(2006.01)*
**C09J 11/06** *(2006.01)*   **C09J 163/00** *(2006.01)*
**H01L 23/29** *(2006.01)*   **H01L 23/31** *(2006.01)*

(52) Cooperative Patent Classification (CPC):
**C08G 59/40; C08L 63/00; C09J 11/06;**
**C09J 163/00; H10W 74/10; H10W 74/40**

(86) International application number:
**PCT/JP2024/033116**

(87) International publication number:
**WO 2025/063171 (27.03.2025 Gazette 2025/13)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **19.09.2023  JP 2023150966**

(71) Applicant: **Asahi Kasei Kabushiki Kaisha**
**Tokyo 1000006 (JP)**

(72) Inventors:
• **MIZUGUCHI Takuya**
  **Tokyo 100-0006 (JP)**
• **KAMIMURA Naoya**
  **Tokyo 100-0006 (JP)**
• **OKAMOTO Ryosuke**
  **Tokyo 100-0006 (JP)**
• **OTONARI Masatoshi**
  **Tokyo 100-0006 (JP)**

(74) Representative: **D Young & Co LLP**
**3 Noble Street**
**London EC2V 7BQ (GB)**

(54) **EPOXY RESIN COMPOSITION, SEALING MATERIAL, SEMICONDUCTOR SEALING MATERIAL, ADHESIVE, CAMERA MODULE, SEMICONDUCTOR PACKAGE, AND ELECTRONIC APPARATUS**

(57)   Provided is an epoxy resin composition comprising an epoxy resin (A) and a curing agent (B), wherein in the curing agent (B),
when a value of a total amine value is defined as (a) and a value of a tertiary amine value is defined as (b), the values of (a) and (b) satisfy the following relational expression (1):

$$(a) - (b) \geq 5.0 \ ... \ (1).$$

EP 4 782 475 A1

## Description

### Technical Field

The present invention relates to an epoxy resin composition, an encapsulant, a semiconductor encapsulant, an adhesive, a camera module, a semiconductor package, and an electronic equipment.

### Background Art

Epoxy resin compositions have heretofore been widely used for various purposes because of their excellent heat resistance and chemical resistance. Particularly, the adhesion of members having low heat resistance, such as lenses or displays, has been required in an increased number of cases in recent years. Thus, there is a demand for epoxy resin compositions that are rapidly cured under a low-temperature condition on the order of, for example, 100°C or lower, and have high adhesive force.

In general, the epoxy resin compositions are known to differ in curing temperature zone depending on the types of curing agents used. For example, most of amine-based curing agents having a primary amino group or a secondary amino group in one molecule cause their reaction with an epoxy group to progress at relatively low temperatures, and the reaction of some of these curing agents progresses around ordinary temperature.

For example, Patent Document 1 discloses a technique of preparing an epoxy resin composition curable even at ordinary temperature using a curing agent for an epoxy resin having a primary amino group and a secondary amino group in one molecule.

### List of Prior Art Documents

### Patent Document

Patent Document 1: Japanese Patent Laid-Open No. 2006-070125

### Summary of Invention

### Problems to be Solved by Invention

Although an epoxy resin composition prepared using a curing agent for an epoxy resin having a primary amino group and a secondary amino group in one molecule, as disclosed in Patent Document 1, exhibits a given effect on reactivity under a low-temperature condition, the adhesive strength of a cured product of the epoxy resin composition cured under a low-temperature condition on the order of 80°C has been found to be reduced after storage in a moist heat environment. Accordingly, the epoxy resin composition has a room for improvement from the viewpoint of moist heat resistance after being cured under a low-temperature condition.

Accordingly, in light of the problems mentioned above, an object of the present invention is to provide an epoxy resin composition that exhibits excellent adhesive strength even when cured under a low-temperature condition, and has a small degree of reduction in adhesive strength even after storage in a moist heat environment.

### Means for Solving Problems

The present inventors have conducted diligent studies to attain the object mentioned above and consequently completed the present invention by finding that in an epoxy resin composition containing an epoxy resin and a curing agent particle, values of a total amine value and a tertiary amine value in the curing agent particle satisfy a predetermined relationship, whereby the problems of the conventional technique mentioned above can be solved.

Specifically, the present invention is as follows.

[1] An epoxy resin composition comprising an epoxy resin (A) and a curing agent (B), wherein

in the curing agent (B),

when a value of a total amine value is defined as (a) and a value of a tertiary amine value is defined as (b), the values of (a) and (b) satisfy the following relational expression (1):

$$(a) - (b) \geq 5.0 \ldots (1).$$

[2] The epoxy resin composition according to [1], wherein
a light transmittance measured at a wavelength of 365 nm by ultraviolet-visible spectroscopy of the curing agent (B) in the form of a solution of 1.0% by mass in dimethylformamide (DMF) is 50.0% or more.

[3] The epoxy resin composition according to [1] or [2], wherein
a viscosity of the epoxy resin composition is 10.0 Pa·s or more and 800.0 Pa·s or less at 25°C.

[4] The epoxy resin composition according to any one of [1] to [3], wherein

the curing agent (B) comprises
at least one or more reaction products of an epoxy resin (C) and an amine compound (D).

[5] The epoxy resin composition according to [4], wherein
the amine compound (D) is an aromatic amine compound or an alicyclic amine compound.

[6] The epoxy resin composition according to [4], wherein
the amine compound (D) is an alicyclic amine compound.

[7] The epoxy resin composition according to any one of [1] to [6], wherein
the curing agent (B) is a curing agent particle.

[8] An epoxy resin composition comprising an epoxy resin (A) and a curing agent particle (B-1), wherein

in the curing agent particle (B-1),

when a value of a total amine value is defined as (a) and a value of a tertiary amine value is defined as (b), the values of (a) and (b) satisfy the following relational expression (1):

$$(a) - (b) \geq 5.0 \ldots (1),$$

the curing agent particle (B-1) comprises

at least one or more reaction products of an epoxy resin (C) and an alicyclic amine compound (D), and

a light transmittance measured at a wavelength of 365 nm by ultraviolet-visible spectroscopy of the curing agent particle (B-1) in the form of a solution of 1.0% by mass in dimethylformamide (DMF) is 50.0% or more.

[9] The epoxy resin composition according to any one of [1] to [8], wherein
the curing agent (B) satisfies the following conditions (i) to (iii):

(i) being a curing agent particle,

(ii) a light transmittance measured at a wavelength of 365 nm by ultraviolet-visible spectroscopy in the form of a solution of 1.0% by mass in dimethylformamide (DMF) is 50.0% or more, and

(iii) comprising at least one or more reaction products of an epoxy resin (C) and an amine compound (D), wherein the amine compound (D) is alicyclic amine.

[10] The epoxy resin composition according to any one of [4] to [9], wherein
the amine compound (D) is 1,3-bis(aminomethyl)cyclohexane.

[11] The epoxy resin composition according to any one of [1] to [10], wherein
the curing agent (B) satisfies the following conditions (i), (ii), and (iv):

(i) being a curing agent particle,

(ii) a light transmittance measured at a wavelength of 365 nm by ultraviolet-visible spectroscopy in the form of a solution of 1.0% by mass in dimethylformamide (DMF) is 50.0% or more, and

(iv) comprising at least one or more reaction products of an epoxy resin (C) and an amine compound (D), wherein the amine compound (D) is 1,3-bis(aminomethyl)cyclohexane.

[12] The epoxy resin composition according to any one of [4] to [11], wherein a content of the amine compound (D) in the curing agent (B) is 0.000001% by mass or more and 3.0% by mass or less.

[13] The epoxy resin composition according to any one of [7] to [12], wherein

when a specific surface area value of the curing agent (B) which is the curing agent particle is defined as (Y) (m$^2$/g) and its particle size D50 at an undersize cumulative fraction of 50% is defined as (X) ($\mu$m),

the values of (X) and (Y) satisfy the following relational expression (2):

$$4.0(X)^{-1} \leq (Y) \leq 8.3(X)^{-1} \ ... \ (2).$$

[14] The epoxy resin composition according to any one of [1] to [13], wherein

a content of the curing agent (B) in the epoxy resin composition is 5.0% by mass or more and 65.0% by mass or less based on the total amount of the epoxy resin (A) and the curing agent (B).

[15] The epoxy resin composition according to any one of [7] to [14], wherein

the curing agent (B) which is the curing agent particle is an encapsulated curing agent having a core particle surface-coated with a shell.

[16] The epoxy resin composition according to any one of [1] to [15], wherein the curing agent (B) satisfies the following conditions (i), (ii), (iv), and (v):

(i) being a curing agent particle,

(ii) a light transmittance measured at a wavelength of 365 nm by ultraviolet-visible spectroscopy in the form of a solution of 1.0% by mass in dimethylformamide (DMF) is 50.0% or more,

(iv) comprising at least one or more reaction products of an epoxy resin (C) and an amine compound (D), wherein the amine compound (D) is 1,3-bis(aminomethyl)cyclohexane, and

(v) being an encapsulated curing agent having a core particle surface-coated with a shell.

[17] The epoxy resin composition according to any one of [1] to [16], wherein

when a gross calorific value measured with a differential scanning calorimeter (DSC) in the epoxy resin composition is defined as (c), and

a gross calorific value measured with a differential scanning calorimeter (DSC) in a cured product of the epoxy resin composition cured at 80°C for 60 minutes is defined as (d),

the values of (c) and (d) satisfy the following relational expression (3):

$$(d)/(c) \times 100 \leq 20.0 ... \ (3).$$

[18] The epoxy resin composition according to any one of [1] to [17], wherein
the curing agent (B) comprises a low-molecular amine compound (E) having a tertiary amino group and having a molecular weight of 1000 or smaller.

[19] The epoxy resin composition according to [18], wherein
the low-molecular amine compound (E) having a tertiary amino group is 1,4-diazabicyclo[2.2.2]octane or (1,4-diazabicyclo[2.2.2]octan-2-yl)methanol.

[20] The epoxy resin composition according to any one of [1] to [19], further comprising
a thiol compound (F).

[21] An encapsulant comprising the epoxy resin composition according to any one of [1] to [20].

[22] An adhesive comprising the epoxy resin composition according to any one of [1] to [20].

[23] A camera module comprising the epoxy resin composition according to any one of [1] to [20].

[24] A semiconductor package comprising the epoxy resin composition according to any one of [1] to [20].

[25] Electronic equipment comprising the epoxy resin composition according to any one of [1] to [20].

**Advantages of Invention**

The present invention can provide an epoxy resin composition that exhibits excellent adhesive strength even when cured under a low-temperature condition, and has a small degree of reduction in adhesive strength even after storage in a moist heat environment.

**Mode for Carrying Out Invention**

Hereinafter, the mode for carrying out the present invention (hereinafter, simply referred to as the "present embodiment") will be described in detail.
The present embodiment given below is an illustration for describing the present invention and does not intend to limit the present invention to the contents given below. The present invention can be carried out through appropriate changes or modifications made without departing from the spirit of the present invention.

[Epoxy resin composition]

The epoxy resin composition of the present embodiment comprises

an epoxy resin (A) and a curing agent (B), wherein

in the curing agent (B),

when a value of a total amine value is defined as (a) and a value of a tertiary amine value is defined as (b), the values of (a) and (b) satisfy the following relational expression (1):

$$(a) - (b) \geq 5.0 \dots (1).$$

The configuration described above can provide an epoxy resin composition that exhibits excellent adhesive strength even when cured under a low-temperature condition, and has a small degree of reduction in adhesive strength even after storage in a moist heat environment.
The viscosity of the epoxy resin composition of the present embodiment is preferably 10.0 Pa·s or more and 800.0 Pa·s or less.
When the viscosity of the epoxy resin composition of the present embodiment is 10.0 Pa·s or more, dripping tends to be easily suppressed when an adherend is coated with the epoxy resin composition of the present embodiment. When the viscosity of the epoxy resin composition of the present embodiment is 800.0 Pa·s or less, adhesive strength for a steel plate tends to be easily controlled because of an increased coating property of the epoxy resin composition of the present embodiment for an adherend.

The lower limit value of the viscosity of the epoxy resin composition of the present embodiment is more preferably 30.0 Pa·s or more, further preferably 50.0 Pa·s or more. The upper limit value of the viscosity of the epoxy resin composition of the present embodiment is more preferably 700 Pa·s or less, further preferably 600 Pa·s or less.

The viscosity of the epoxy resin composition can be measured by a method described in Examples mentioned later, and can be controlled to the numeric range mentioned above by changing the type of the epoxy resin or the curing agent.

When a gross calorific value measured with a differential scanning calorimeter (DSC) in the epoxy resin composition of the present embodiment is defined as (c), and a gross calorific value measured with a differential scanning calorimeter (DSC) in a cured product of the epoxy resin composition cured at 80°C for 60 minutes is defined as (d), the values of (c) and (d) preferably satisfy the following relational expression (3):

$$(d)/(c) \times 100 \leq 20.0 \ldots (3).$$

The epoxy resin composition of the present embodiment satisfies the relational expression (3) and can thereby provide an epoxy resin composition that exhibits excellent adhesive strength even when cured under a low-temperature condition, and has a small degree of reduction in adhesive strength even after storage in a moist heat environment.

This is presumably because of the following.

The adhesive strength of the epoxy resin composition correlates with the degree of progression of the reaction between the epoxy resin and the curing agent after thermal curing. As the reaction progresses, the adhesive strength tends to rise.

The value of $(d)/(c) \times 100$ in the relational expression (3) is an index that indicates the amounts of the epoxy resin (A) and the curing agent (B) unreacted.

When the value of $(d)/(c) \times 100$ is 20.0 or less, this means that practically sufficient adhesive strength is obtained because of small amounts of the epoxy resin and the curing agent unreacted. Accordingly, the epoxy resin composition preferably satisfies the relational expression (3).

The value of $(d)/(c) \times 100$ is preferably 10.0 or less, more preferably 5.0 or less, further preferably 2.0 or less, from the viewpoint of the adhesive strength of the epoxy resin composition of the present embodiment.

Examples of the method for controlling the value of $(d)/(c) \times 100$ include a method of preparing the curing agent (B) as particles and coating the surface of the particles with a shell, a method of attaching compositionally different materials to the particle surface, and a method of enhancing reactivity by adjusting the type of a material constituting the curing agent particles.

(Epoxy resin (A))

The epoxy resin composition of the present embodiment comprises an epoxy resin (A).

A conventionally known epoxy resin can be used as the epoxy resin (A). Examples of thereof include, but are not limited to: bifunctional epoxy resins such as bisphenol A-type epoxy resin, bisphenol F-type epoxy resin, bisphenol AD-type epoxy resin, bisphenol M-type epoxy resin, bisphenol P-type epoxy resin, tetrabromobisphenol A-type epoxy resin, biphenyl-type epoxy resin, tetramethylbiphenyl-type epoxy resin, tetrabromobiphenyl-type epoxy resin, diphenyl ether-type epoxy resin, benzophenone-type epoxy resin, phenyl benzoate-type epoxy resin, diphenyl sulfide-type epoxy resin, diphenyl sulfoxide-type epoxy resin, diphenylsulfone-type epoxy resin, diphenyl disulfide-type epoxy resin, naphthalene-type epoxy resin, anthracene-type epoxy resin, hydroquinone-type epoxy resin, methylhydroquinone-type epoxy resin, dibutylhydroquinone-type epoxy resin, resorcinol-type epoxy resin, methylresorcinol-type epoxy resin, and catechol-type epoxy resin; trifunctional epoxy resins such as N,N-diglycidyl aminobenzene-type epoxy resin and triazine-type epoxy resin; tetrafunctional epoxy resins such as tetraglycidyl diaminodiphenylmethane-type epoxy resin and diaminobenzene-type epoxy resin; polyfunctional epoxy resins such as phenol novolac-type epoxy resin, cresol novolac-type epoxy resin, triphenylmethane-type epoxy resin, tetraphenylethane-type epoxy resin, dicyclopentadiene-type epoxy resin, naphthol aralkyl-type epoxy resin, and brominated phenol novolac-type epoxy resin; and alicyclic epoxy resins.

One of these epoxy resins may be used singly, or two or more thereof may be used in combination.

Alternatively, for example, an epoxy resin obtained by modifying any of these epoxy resins with isocyanate or the like may be used in combination therewith as the epoxy resin (A).

The epoxy resin composition of the present embodiment preferably comprises a bisphenol-type epoxy resin as the epoxy resin (A) from the viewpoint of handleability and heat resistance, more preferably comprises bisphenol F-type epoxy resin from the viewpoint of conferring preservation stability and favorable reactivity, and further preferably comprises bisphenol A-type epoxy resin from the viewpoint of conferring sufficient mechanical characteristics.

The epoxy resin composition comprising bisphenol F-type epoxy resin as well as bisphenol A-type epoxy resin exerts much better preservation stability and better reactivity. This mechanism is presumably based on the following, though not intending to be limited thereto. The bisphenol A-type epoxy resin contained therein suppresses the aggregation of molecules of the bisphenol F-type epoxy resin. This improves the homogeneity of the epoxy resin composition of the present embodiment and improves preservation stability. In addition, reactivity is improved by enhanced diffusivity of molecules after the start of curing.

The total chlorine content of the epoxy resin (A) is preferably 2500 ppm or less, more preferably 1500 ppm or less, further preferably 900 ppm or less, from the viewpoint of obtaining an epoxy resin composition that has excellent balance between curability and storage stability while having excellent electric characteristics.

The total chlorine content of the epoxy resin (A) is preferably 0.01 ppm or more, more preferably 0.1 ppm or more, further preferably 0.5 ppm or more, from the viewpoint of achieving predetermined technical significance, for example, practically favorable productivity.

In this context, the total chlorine content refers to the total amount of organic chlorine and inorganic chlorine contained in the epoxy resin (A), and is a value based on mass based on the epoxy resin (A).

The total chlorine content of the epoxy resin (A) is measured by the following method: the epoxy resin (A) is repetitively washed and filtered using trimethylbenzene until the epoxy resin is no longer found in a washing solution xylene. Next, the solvent in the filtrate is distilled off under reduced pressure at 100°C or lower to obtain an epoxy resin. 1 to 10 g of the obtained epoxy resin sample is precisely weighed such that a titer is 3 to 7 mL. This sample is dissolved in 25 mL of ethylene glycol monobutyl ether. To this solution, 25 mL of a solution of 1 N KOH in propylene glycol is added, and the mixture is boiled for 20 minutes, followed by titration with an aqueous silver nitrate solution. The total chlorine content is calculated from the resulting titer.

(Curing agent (B))

The epoxy resin composition of the present embodiment comprises a curing agent (B).

The curing agent (B) of the present embodiment is preferably a particle (hereinafter, also referred to as a curing agent particle (B) or a curing agent particle (B-1)) from the viewpoint of preservation stability.

The curing agent particle (B) for use in the epoxy resin composition of the present embodiment is preferably a curing agent that is a solid at 25°C at 1013 hPa.

The curing agent particle (B) is dispersed in the epoxy resin composition, and curing reaction is started at a predetermined temperature and after a lapse of a predetermined time after the start of heating. This mechanism can provide an epoxy resin composition that achieves both of reactivity and storage stability.

The curing agent (B) for use in the epoxy resin composition of the present embodiment is preferably a curing agent particle and an encapsulated curing agent having a core particle surface-coated with a shell.

The curing agent particle (B) thus configured can provide an epoxy resin composition that has a low residual calorific value measured with a differential scanning calorimeter (DSC) even when cured under a low-temperature condition, and has a small degree of reduction in adhesive strength even after storage in a moist heat environment. This is presumably because of the following.

The residual calorific value measured with a differential scanning calorimeter (DSC) is an index that indicates the amounts of the epoxy resin (A) and the curing agent particles (B) unreacted. In the case of curing under a low-temperature condition using curing agent particles having no coating layer of microcapsules, an unreacted epoxy resin and curing agent particles remain and tend to increase a residual calorific value, though curing reaction progresses. This is because, due to low reaction start temperatures of a primary amino group and a secondary amino group in the curing agent particles, the reaction of the curing agent particles with their surrounding epoxy resin progresses before the curing agent particles are dissolved and diffused in the epoxy resin. As a result, the curing agent particles are left behind in the cured epoxy resin and thus cannot be diffused so that an unreacted epoxy resin and curing agent particles remain.

On the other hand, in the case of using a microencapsulated curing agent having a core particle surface-coated with a shell as the curing agent particle (B), the reaction of the epoxy resin with a curing agent component is not started until an arbitrary temperature owing to the shielding effect of a capsule membrane. After reaching the arbitrary temperature, the curing agent component is rapidly diffused. Therefore, the whole epoxy resin composition is uniformly cured, and the residual calorific value is decreased. Accordingly, the degree of reduction in adhesive strength is also decreased after storage in a moist heat environment. The optimum contents of a primary amino group and a secondary amino group in the curing agent particle will be mentioned later.

The residual calorific value measured with a differential scanning calorimeter (DSC) in a cured product of the epoxy resin composition of the present embodiment cured at 80°C for 60 minutes is preferably 20.0% or less, more preferably 10.0% or less, further preferably 5.0% or less, still further preferably 2.0% or less. As a result, the amounts of unreacted epoxy resin and curing agent particles remaining are sufficiently low, and a uniformly cured product is obtained. The degree of reduction in adhesive strength is sufficiently small after storage in a moist heat environment.

Examples of the method for controlling the value of the residual calorific value measured with a differential scanning calorimeter (DSC) in the epoxy resin composition include a method of coating the surface of the curing agent particle (B) with a microcapsule shell, and a method of adjusting the type of a material constituting the curing agent particle.

Specifically, the residual calorific value of the epoxy resin composition of the present embodiment can be measured by a method described in Examples mentioned later.

The particle size D50 of the curing agent particle (B) at undersize cumulative fraction of 50% is preferably larger than 0.3 $\mu$m and 12 $\mu$m or smaller.

The D50 of the curing agent particle (B) is larger than 0.3 $\mu$m, whereby effects can be obtained which can further prevent the aggregation of cores, further facilitate forming a microcapsule coating layer, and attain practically sufficient preservation stability of the epoxy resin composition of the present embodiment.

The D50 of the curing agent particle (B) is 12 $\mu$m or smaller, whereby the epoxy resin composition of the present embodiment can produce a homogeneous cured product when cured. The D50 of the curing agent particle (B) is 12 $\mu$m or smaller, whereby the epoxy resin composition of the present embodiment can be prevented from forming aggregates with a large particle size when blended with a diluent, a filler, a pigment, a dye, a flow adjuster, a thickener, a reinforcing agent, a mold release agent, a wetting agent, a stabilizer, a flame retardant, a surfactant, an organic solvent, a conductive fine particle, a crystalline alcohol, other resins, and the like. The resulting cured product has sufficient long-term reliability.

The lower limit value of the range of the D50 of the curing agent particle (B) is preferably larger than 0.3 $\mu$m, more preferably 0.4 $\mu$m or larger, further preferably 0.5 $\mu$m or larger. The upper limit value is preferably 12 $\mu$m or smaller, more preferably 10 $\mu$m or smaller, further preferably 9 $\mu$m or smaller.

When a specific surface area value of the curing agent particle (B) for use in the epoxy resin composition of the present embodiment is defined as (Y) (m$^2$/g) and its particle size D50 at an undersize cumulative fraction of 50% is defined as (X) ($\mu$m), the values of (X) and (Y) preferably satisfy the following relational expression (2):

$$4.0(X)^{-1} \leq (Y) \leq 8.3(X)^{-1} ... (2).$$

The curing agent particle (B) thus configured facilitates uniformly coating the surface of a core particle with a microcapsule layer. As a result, the whole epoxy resin composition is uniformly cured even when cured under a low-temperature condition, and an epoxy resin composition having a small degree of reduction in adhesive strength even after storage in a moist heat environment is easily prepared. Furthermore, improved storage stability and a decreased viscosity of an epoxy resin formulation can be expected.

The value (X) ($\mu$m) of the particle size D50 of the curing agent particle (B) at an undersize cumulative fraction of 50% can be controlled by a method of elevating a grinding pressure in a grinding step, or accelerating a starting material feed rate in a grinding step, for example. The specific surface area value (Y) (m$^2$/g) of the curing agent particle (B) can be controlled by a method of correcting a shape by physical collision between the curing agent particles or a method of correcting a shape using heat. These values can be adjusted and thereby controlled so as to satisfy the relational expression (2).

The particle size D50 and the specific surface area value of the curing agent particle (B) can be measured by methods described in Examples mentioned later.

The content of the curing agent (B) in the epoxy resin composition of the present embodiment is preferably 5.0% by mass or more and 65.0% by mass or less, more preferably 10.0% by mass or more and 60.0% by mass or less, further preferably 15.0% by mass or more and 55.0% by mass or less, based on the total amount of the epoxy resin (A) and the curing agent (B).

When the content of the curing agent (B) falls within the range described above, whereby the resulting epoxy resin composition tends to be excellent in balance between curability and viscosity.

In the curing agent (B), as mentioned above, when a value of a total amine value is defined as (a) and a value of a tertiary amine value is defined as (b), the values of (a) and (b) satisfy the following relational expression (1):

$$(a) - (b) \geq 5.0 ... (1).$$

The curing agent (B) that satisfies the relational expression (1) can provide an epoxy resin composition that exhibits excellent adhesive strength even when cured under a low-temperature condition, and has a small degree of reduction in adhesive strength even after storage in a moist heat environment.

This is presumably because of the following.

The adhesive strength of the epoxy resin composition correlates with the degree of progression of the reaction between the epoxy resin and the curing agent after thermal curing. As the reaction progresses, the adhesive strength tends to rise. As mentioned above, use of a curing agent having a primary amino group and a secondary amino group in one molecule causes its reaction with an epoxy group to progress at low temperatures and can therefore enhance adhesive strength.

The value of (a) - (b) refers to the total amount of a primary amino group and a secondary amino group. The curing agent that satisfies the relational expression (1) is meant to contain a primary amino group and a secondary amino group.

When the value of (a) - (b) is 5.0 or more, sufficient reactivity is obtained under a low-temperature condition and allows the reaction between the epoxy resin and the curing agent to progress. Also, practically sufficient adhesive strength is obtained. Accordingly, the curing agent (B) is required to satisfy the relational expression (1).

The lower limit value of (a) - (b) is preferably 30.0 or more, more preferably 60.0 or more, further preferably 100.0 or more, from the viewpoint of the adhesive strength of the epoxy resin composition of the present embodiment. The upper limit value of (a) - (b) is not particularly limited and is preferably 500 or less, more preferably 450 or less, further preferably 400 or less, from the viewpoint of the preservation stability of the epoxy resin composition of the present embodiment.

Examples of the method for controlling the value of (a) - (b) include a method of selecting the type of a starting material amine of the curing agent (B), and a method of adding an additive to the curing agent (B).

The total amine value, the tertiary amine value, and the value of (a) - (b) of the curing agent (B) for use in the epoxy resin composition of the present embodiment can be measured by methods described in Examples mentioned later.

The value (a) of the total amine value of the curing agent (B) is preferably 60 or more, more preferably 100 or more, further preferably 150 or more, still further preferably 200 or more, from the viewpoint of the flexural strength of a cured product of the epoxy resin composition of the present embodiment.

The upper limit value of the value (a) of the total amine value of the curing agent (B) is not particularly limited and is preferably 500 or less, more preferably 450 or less, further preferably 400 or less, from the viewpoint of the preservation stability of the epoxy resin composition of the present embodiment.

The value (a) of the total amine value of the curing agent (B) can be controlled to the numeric range described above by appropriately selecting the type of a starting material amine of the curing agent (B).

The curing agent (B) preferably comprises at least one or more reaction products of an epoxy resin (C) and an amine compound (D).

The curing agent (B) thus configured tends to facilitate preparing an epoxy resin composition that achieves both of reactivity and storage stability.

The epoxy resin (C) constituting the curing agent (B) is not limited, and either a monoepoxy compound or a polyvalent epoxy compound, or a mixture thereof is used, for example.

Examples of the monoepoxy compound include, but are not limited to, butyl glycidyl ether, hexyl glycidyl ether, phenyl glycidyl ether, allyl glycidyl ether, para-tert-butylphenyl glycidyl ether, ethylene oxide, propylene oxide, paraxylyl glycidyl ether, glycidyl acetate, glycidyl butyrate, glycidyl hexoate, and glycidyl benzoate.

Examples of the polyvalent epoxy compound include, but are not limited to: bisphenol-type epoxy resins obtained by the glycidylation of bisphenols such as bisphenol A, bisphenol F, bisphenol AD, bisphenol S, tetramethyl bisphenol A, tetramethyl bisphenol F, tetramethyl bisphenol AD, tetramethyl bisphenol S, tetrabromobisphenol A, tetrachlorobisphenol A, and tetrafluorobisphenol A; epoxy resins obtained by the glycidylation of other dihydric phenols such as biphenol, dihydroxynaphthalene, and 9,9-bis(4-hydroxyphenyl)fluorene; epoxy resins obtained by the glycidylation of trisphenols such as 1,1,1-tris(4-hydroxyphenyl)methane and 4,4-(1-(4-(1-(4-hydroxyphenyl)-1-methylethyl)phenyl)ethylidene)bisphenol; epoxy resins obtained by the glycidylation of tetrakisphenols such as 1,1,2,2-tetrakis(4-hydroxyphenyl)ethane; novolac-type epoxy resins obtained by the glycidylation of novolacs such as phenol novolac, cresol novolac, bisphenol A novolac, brominated phenol novolac, and brominated bisphenol A novolac; epoxy resins obtained by the glycidylation of polyhydric phenols; aliphatic ether-type epoxy resins obtained by the glycidylation of polyhydric alcohols such as glycerin and polyethylene glycol; ether ester-type epoxy resins obtained by the glycidylation of hydroxycarboxylic acids such as p-oxybenzoic acid and β-oxynaphthoic acid; ester-type epoxy resins obtained by the glycidylation of polycarboxylic acids such as phthalic acid and terephthalic acid; glycidyl-type epoxy resins such as glycidylation products of amine compounds such as 4,4-diaminodiphenylmethane and m-aminophenol, and amine-type epoxy resins such as triglycidyl isocyanurate; and aliphatic epoxide such as 3,4-epoxycyclohexylmethyl-3',4'-epoxycyclohexane carboxylate.

In this context, the epoxy resin (C) is preferably a polyvalent epoxy compound, more preferably a glycidyl-type epoxy resin, from the viewpoint of more enhancing the storage stability of the epoxy resin composition of the present embodiment. Among them, an epoxy resin obtained by the glycidylation of a polyhydric phenol, particularly, a bisphenol-type epoxy resin, is particularly preferred from the viewpoint of more improving the adhesiveness and heat resistance of a cured product. More specifically, an epoxy resin obtained by the glycidylation of bisphenol A or an epoxy resin obtained by the glycidylation of bisphenol F is suitable. Particularly, an epoxy resin obtained by the glycidylation of bisphenol A is more preferred.

One of these epoxy resins may be used singly, or two or more thereof may be used in combination.

Examples of the amine compound (D) constituting the curing agent (B) include, but are not limited to, aliphatic amine compounds, alicyclic amine compounds, and aromatic amine compounds. Among them, an alicyclic amine compound or an aromatic amine compound is preferred from the viewpoint of improving Tg of a cured product of the epoxy resin composition of the present embodiment. More specifically, an alicyclic amine compound is further preferred from the viewpoint of the adhesiveness and reaction rate of the epoxy resin composition of the present embodiment.

Examples of the aliphatic amine compound include, but are not limited to, methylamine, ethylamine, propylamine, butylamine, ethylenediamine, propylenediamine, hexamethylenediamine, diethylenetriamine, triethylenetetramine, tetraethylenepentamine, trimethylhexamethylenediamine, 2-methylpentamethylenediamine, ethanolamine, propanolamine, N,N-dimethylaminopropylamine, and N,N-dimethylethylenediamine.

Examples of the aromatic amine compound include, but are not limited to, aniline, toluidine, diaminodiphenylmethane, diaminodiphenylsulfone, phenylmethylamine, phenylethylamine, o-xylenediamine, m-xylenediamine, p-xylenediamine, 1,2-phenylenediamine, 1,3-phenylenediamine, and 1,4-phenylenediamine.

Examples of the alicyclic amine compound include, but are not limited to, cyclohexylamine, isophoronediamine, 1,2-diaminocyclohexane, 1,3-diaminocyclohexane, 1,4-diaminocyclohexane, 1,3-bisaminomethylcyclohexane, 1,4-bisaminomethylcyclohexane, bis(4-aminocyclohexyl)methane, norbornenediamine, and N,N-dimethyl-1,4-cyclohexanediamine. Among them, 1,3-bisaminomethylcyclohexane is preferred from the viewpoint of the crack resistance of a cured product.

The content of the amine compound (D) in the curing agent (B) is preferably 0.000001% by mass or more and 3.0% by mass or less. The content is more preferably 0.000001% by mass or more and 2.0% by mass or less, further preferably 0.000001% by mass or more and 1.0% by mass or less, still further preferably 0.000001% by mass or more and 0.5% by mass or less.

The content of the amine compound (D) in the curing agent (B) falls within the range described above, whereby the resulting epoxy resin composition tends to have favorable storage stability.

The content of the amine compound (D) in the curing agent (B) can be controlled to the numeric range described above by adjusting a temperature, the degree of pressure reduction, and a pressure reduction time in a distillation step after production of a reaction product of the epoxy resin (C) and the amine compound (D).

In the curing agent (B), the light transmittance measured at a wavelength of 365 nm by ultraviolet-visible spectroscopy in a solution containing 1.0% by mass of the curing agent (B) in dimethylformamide (DMF) is preferably 50.0% or more. The light transmittance is more preferably 70.0% or more, further preferably 90.0% or more.

The light transmittance of the curing agent (B) falls within the range described above, whereby the resulting epoxy resin composition exhibits favorable light permeability and can also be suitably used as an adhesive for photocuring purposes. The light transmittance of the curing agent (B) can be controlled to the numeric range described above, for example, by compositionally adjusting a material constituting the curing agent (B), adjusting the amount of an additive, or avoiding contact with oxygen during heating in the process of producing the curing agent (reaction step and desolvation step).

The light transmittance can be measured by a method described in Examples mentioned later.

As mentioned above, the curing agent (B) is preferably a curing agent particle (B-1).

As mentioned above, the curing agent (B) preferably comprises at least one or more reaction products of an epoxy resin (C) and an amine compound (D).

As mentioned above, the light transmittance measured at a wavelength of 365 nm by ultraviolet-visible spectroscopy of the curing agent (B) in the form of a solution of 1.0% by mass in dimethylformamide (DMF) is preferably 50.0% or more.

Specifically, a preferred form of the epoxy resin composition of the present embodiment is an epoxy resin composition comprising an epoxy resin (A) and a curing agent particle (B-1), wherein in the curing agent particle (B-1), when a value of a total amine value is defined as (a) and a value of a tertiary amine value is defined as (b), the values of (a) and (b) satisfy the following relational expression (1):

$$(a) - (b) \geq 5.0 \ ... \ (1),$$

the curing agent particle (B-1) comprises at least one or more reaction products of an epoxy resin (C) and an alicyclic amine compound (D), and a light transmittance measured at a wavelength of 365 nm by ultraviolet-visible spectroscopy of the curing agent particle (B-1) in the form of a solution of 1.0% by mass in dimethylformamide (DMF) is 50.0% or more.

The epoxy resin composition of the present embodiment may comprise a curing agent other than the curing agent particle (B-1).

As mentioned above, the amine compound (D) is preferably an alicyclic compound.

Specifically, in a preferred form of the epoxy resin composition of the present embodiment, the curing agent (B) satisfies the following conditions (i) to (iii):

(i) being a curing agent particle (B-1),
(ii) a light transmittance measured at a wavelength of 365 nm by ultraviolet-visible spectroscopy in the form of a solution of 1.0% by mass in dimethylformamide (DMF) is 50.0% or more, and
(iii) comprising at least one or more reaction products of an epoxy resin (C) and an amine compound (D), wherein the amine compound (D) is alicyclic amine.

As mentioned above, the amine compound (D) is preferably 1,3-bis(aminomethyl)cyclohexane.

Specifically, in a preferred form of the epoxy resin composition of the present embodiment, the curing agent (B) satisfies the following conditions (i), (ii), and (iv):

(i) being a curing agent particle (B-1),
(ii) a light transmittance measured at a wavelength of 365 nm by ultraviolet-visible spectroscopy in the form of a solution of 1.0% by mass in dimethylformamide (DMF) is 50.0% or more, and
(iv) comprising at least one or more reaction products of an epoxy resin (C) and an amine compound (D), wherein the amine compound (D) is 1,3-bis(aminomethyl)cyclohexane.

As mentioned above, the curing agent (B) is preferably a curing agent particle (B-1) and an encapsulated curing agent having a core particle surface-coated with a shell.

Specifically, in a preferred form of the epoxy resin composition of the present embodiment, the curing agent (B) satisfies the following conditions (i), (ii), (iv), and (v):

(i) being a curing agent particle (B-1),

(ii) a light transmittance measured at a wavelength of 365 nm by ultraviolet-visible spectroscopy in the form of a solution of 1.0% by mass in dimethylformamide (DMF) is 50.0% or more,

(iv) comprising at least one or more reaction products of an epoxy resin (C) and an amine compound (D), wherein the amine compound (D) is 1,3-bis(aminomethyl)cyclohexane, and

(v) being an encapsulated curing agent having a core particle surface-coated with a shell.

The preferred forms mentioned above tend to produce an epoxy resin composition that achieves both of reactivity and storage stability.

The curing agent (B) preferably comprises a low-molecular amine compound (E) having a tertiary amino group and having a molecular weight of 1000 or smaller, aside from the amine compound (D) contained in the curing agent (B) from the viewpoint of reactivity.

The content of the low-molecular amine compound (E) in the curing agent (B) is preferably 0.1% by mass or more and 30.0% by mass or less, more preferably 1.0% by mass or more and 25.0% by mass or less, further preferably 2.0% by mass or more and 20.0% by mass or less.

The curing agent (B) comprises the low-molecular amine compound (E) having a tertiary amino group, whereby the curing agent (B) can be suitably used as an accelerator for a curing agent composed of a thiol compound. Specifically, the epoxy resin composition of the present embodiment preferably comprises an epoxy resin (A), a curing agent (B) comprising a low-molecular amine compound (E) having a tertiary amino group, and a curing agent (F) composed of a thiol compound.

The content of the low-molecular amine compound (E) having a tertiary amino group is preferably 0.001 parts by mass or more and 10.0 parts by mass or less, more preferably 0.005 parts by mass or more and 7.5 parts by mass or less, further preferably 0.01 parts by mass or more and 5.0 parts by mass or less, per 100 parts by mass of the epoxy resin (A). The content of the low-molecular amine compound (E) having a tertiary amino group falls within the range described above and can thereby provide an epoxy resin composition excellent in balance between reactivity and storage stability.

The content of the low-molecular amine compound (E) having a tertiary amino group in the epoxy resin composition of the present embodiment can be controlled to the numeric range described above by adjusting the amount of the added low-molecular amine compound (E) having a tertiary amino group in the curing agent (B), or adjusting the amount of the curing agent (B) added.

Examples of the low-molecular amine compound (E) having a tertiary amino group include, but are not limited to: tertiary amines such as trimethylamine, triethylamine, benzyldimethylamine, N,N-dimethyl-ethylamine, N,N-dimethylbutylamine, N,N-dimethyldecylamine, N,N-dimethyl-m-toluidine, N,N-dimethyl-p-toluidine, 2,6,10-trimethyl-2,6,10-triazaundecane, N,N'-dimethylpiperazine, 1,4-diazabicyclo[2.2.2]octane, (1,4-diazabicyclo[2.2.2]octan-2-yl)methanol, 1-azabicyclo[2.2.2]octan-3-one, 1, 8-diazabicyclo(5,4,0)-undecene-7, 1, 5-diazabicyclo(4,3,0)-nonene-5, and hexamethylenetetramine; imidazoles such as 1-methylimidazole, 1,2-dimethylimidazole, 1-vinylimidazole, 1-allylimidazole, 2-methyl-1-vinylimidazole, and N-acetylimidazole; aromatic tertiary amines such as dimethylaminobenzhydrol, bis[4-(dimethylamino)phenyl]methane, 4,4'-bis(dimethylamino)benzophenone, and 2-diethylamino-N-(2,6-dimethylphenyl)acetamide; and aminopyridines having a tertiary amino group, such as 2-dimethylaminopyridine and 4-dimethylaminopyridine.

In this context, the low-molecular amine compound (E) having a tertiary amino group is preferably 1,4-diazabicyclo[2.2.2]octane or (1,4-diazabicyclo[2.2.2]octan-2-yl)methanol from the viewpoint of reactivity when used as an accelerator for the thiol curing agent. One of these amine compounds may be used singly, or two or more thereof may be used in combination.

The curing agent (B) for use in the epoxy resin composition of the present embodiment is preferably a curing agent particle, more preferably a microencapsulated curing agent having a core particle surface-coated with a shell, as mentioned above.

The shell preferably comprises a synthetic resin and/or an inorganic oxide. Among them, a material constituting the shell preferably comprises a synthetic resin from the viewpoint of the stability and ease of breaking during heating of a membrane constituting the shell, and the homogeneity of a cured product of the epoxy resin composition of the present embodiment.

Examples of the synthetic resin contained in the shell constituting the curing agent particle (B) include, but are not limited to, epoxy-based resins, phenol-based resins, polyester-based resins, polyethylene-based resins, nylon-based resins, polystyrene-based resins, and urethane-based resins.

Among them, the synthetic resin is preferably an epoxy-based resin, a phenol-based resin, or a urethane-based resin from the viewpoint of the balance between the stability and breaking property during heating of a membrane constituting the shell.

Examples of the epoxy-based resin for use in the shell include, but are not limited to, epoxy resins having two or more epoxy groups, resins produced through the reaction of an epoxy resin having two or more epoxy groups with a compound having two or more active hydrogen moieties, and reaction products of a compound having two or more epoxy groups and a compound having one active hydrogen moiety and a carbon-carbon double bond.

Among them, a resin produced through the reaction of a compound having two or more epoxy groups with a compound having two or more active hydrogen moieties is preferred, and, particularly, a reaction product of an amine-based curing agent and an epoxy resin having two or more epoxy groups is more preferred, from the viewpoint of stability.

Examples of the phenol-based resin for use in the shell include, but are not limited to, phenol-formaldehyde polycondensates, cresol-formaldehyde polycondensates, resorcinol-formaldehyde polycondensates, bisphenol A-formaldehyde polycondensates, and polyethylene polyamine modification products of phenol-formaldehyde polycondensates.

Examples of the polyester-based resin for use in the shell include, but are not limited to, ethylene glycol-terephthalic acid-polypropylene glycol polycondensates, ethylene glycol-butylene glycol-terephthalic acid polycondensates, and terephthalic acid-ethylene glycol-polyethylene glycol polycondensates.

Examples of the polyethylene-based resin for use in the shell include, but are not limited to, ethylene-propylene-vinyl alcohol copolymers, ethylene-vinyl acetate copolymers, and ethylene-vinyl acetate-acrylic acid copolymers.

Examples of the nylon-based resin for use in the shell include, but are not limited to, adipic acid-hexamethylenediamine polycondensates, sebacic acid-hexamethylenediamine polycondensates, and p-phenylenediamine-terephthalic acid polycondensates.

Examples of the polystyrene-based resin for use in the shell include, but are not limited to, styrene-butadiene copolymers, styrene-butadiene-acrylonitrile copolymers, acrylonitrile-styrene-divinylbenzene copolymers, and styrene-propenyl alcohol copolymers.

Examples of the urethane-based resin for use in the shell include, but are not limited to, isocyanate monomers such as butyl isocyanate, cyclohexyl isocyanate, octadecyl isocyanate, phenyl isocyanate, tolylene diisocyanate, diphenylmethane diisocyanate, xylylene diisocyanate, hexamethylene diisocyanate, isophorone diisocyanate, tolidine diisocyanate, naphthalene diisocyanate, and triphenylmethane triisocyanate, and condensates thereof, and polycondensates of polymers thereof and monoalcohols or polyhydric alcohols.

Among them, a urethane resin which is an addition polymer of a monoalcohol or a polyhydric alcohol and monoisocyanate or polyvalent isocyanate is preferred.

Examples of the inorganic oxide for use in the shell include, but are not limited to, boron compounds such as boron oxide and boric acid ester, silicon dioxide, and calcium oxide.

Among them, boron oxide is preferred from the viewpoint of the stability and ease of breaking during heating of a membrane constituting the shell.

The shell constituting the curing agent particle (B) preferably has a urea bond group which absorbs infrared ray with a wave number of 1630 to 1680 cm$^{-1}$, a biuret bond group which absorbs infrared ray with a wave number of 1680 to 1725 cm$^{-1}$, and a urethane bond group which absorbs infrared ray with a wave number of 1730 to 1755 cm$^{-1}$, from the viewpoint of the balance between preservation stability and reactivity.

The urea bond group, the biuret bond group, and the urethane bond group can be detected by measurement using a Fourier transform infrared spectrophotometer (hereinafter, also referred to as "FT-IR"). The presence of the urea bond group, the biuret bond group, or the urethane bond group in the shell can be confirmed with microscopic FT-IR.

Specifically, a modified aliphatic polyamine curing agent is added to the epoxy resin composition of the present embodiment, which is then cured at 40°C over 12 hours. Then, the epoxy resin moiety is completely cured at 120°C over 24 hours. Then, a 5 to 20 μm thick sample is prepared from the obtained cured product using an ultramicrotome and analyzed in the depth direction of the shell with microscopic FT-IR. The presence of the urea bond group, the biuret bond group, or the urethane bond group can be observed by observing the vicinity of the surface of the shell.

The content of the curing agent particle (B) in the epoxy resin composition of the present embodiment is preferably 5.0% by mass or more and 65.0% by mass or less based on the total amount of the epoxy resin (A) and the curing agent particle (B) from the viewpoint of the reactivity and viscosity of the epoxy resin composition. The content is more preferably 10.0% by mass or more, further preferably 15.0% by mass or more. The content is more preferably 60.0% by mass or less, further preferably 55.0% by mass or less.

(Thiol compound (F))

The epoxy resin composition of the present embodiment may comprise a curing agent (F) composed of a thiol compound, as mentioned above.

The content of the thiol compound (F) in the epoxy resin composition of the present embodiment is preferably 0.3 or more and 2.5 or less, more preferably 0.5 or more and 2.0 or less, further preferably 0.7 or more and 1.5 or less, in terms of the ratio of a thiol equivalent to the epoxy equivalent of the epoxy resin (A). The content of the thiol compound (F) falls within the range described above, whereby the resulting cured product tends to be excellent in adhesive strength.

The thiol compound (F) preferably has two or more thiol groups in a molecule.

The thiol compound (F) preferably comprises a thiol compound having no ester bond.

Use of the thiol compound having no ester bond tends to allow a cured product of the epoxy resin composition of the present embodiment to resist hydrolysis even under a high-temperature and humid condition, and enhances the reliability of adhesive strength.

The thiol compound (F) may comprise a polyfunctional thiol compound having an ester bond.

Examples of the polyfunctional thiol compound having an ester bond include, but are not limited to, trimethylolpropane tris(3-mercaptopropionate) (manufactured by SC Organic Chemical Co., Ltd.; TMMP), pentaerythritol tetrakis(3-mercaptopropionate) (manufactured by SC Organic Chemical Co., Ltd.; PEMP), tetraethylene glycol bis(3-mercaptopropionate) (manufactured by SC Organic Chemical Co., Ltd.; EGMP-4), dipentaerythritol hexakis(3-mercaptopropionate) (manufactured by SC Organic Chemical Co., Ltd.; DPMP), pentaerythritol tetrakis(3-mercaptobutyrate) (manufactured by Showa Denko K.K.; KarenzMT(R) PE1), tris-[(3-mercaptopropionyloxy)-ethyl]-isocyanurate (manufactured by SC Organic Chemical Co., Ltd.; TEMPIC), and 1,3,5-tris(3-mercaptobutyryloxyethyl)-1,3,5-triazine-2,4,6(1H,3H,5H)-trione (manufactured by Showa Denko K.K.; KarenzMT(R) NR1).

Examples of the thiol compound having no ester bond include, but are not limited to, 1,3,4,6-tetrakis(2-mercaptoethyl) glycoluril (trade name: TS-G, manufactured by Shikoku Kasei Holdings Corp.), (1,3,4,6-tetrakis(3-mercaptopropyl) glycoluril (trade name: C3 TS-G, manufactured by Shikoku Kasei Holdings Corp.), 1,3,4,6-tetrakis(mercaptomethyl) glycoluril, 1,3,4,6-tetrakis(mercaptomethyl)-3a-methyl glycoluril, 1,3,4,6-tetrakis(2-mercaptoethyl)-3a-methyl glycoluril, 1,3,4,6-tetrakis(3-mercaptopropyl)-3a-methyl glycoluril, 1,3,4,6-tetrakis(mercaptomethyl)-3a,6a-dimethyl glycoluril, 1,3,4,6-tetrakis(2-mercaptoethyl)-3a,6a-dimethyl glycoluril, 1,3,4,6-tetrakis(3-mercaptopropyl)-3a,6a-dimethyl glycoluril, 1,3,4,6-tetrakis(mercaptomethyl)-3a,6a-diphenyl glycoluril, 1,3,4,6-tetrakis(2-mercaptoethyl)-3a,6a-diphenyl glycoluril, 1,3,4,6-tetrakis(3-mercaptopropyl)-3a,6a-diphenyl glycoluril, pentaerythritol tripropanethiol (trade name: PEPT, manufactured by SC Organic Chemical Co., Ltd.), pentaerythritol tetrapropanethiol (trade name: Multhiol Y4, manufactured by SC Organic Chemical Co., Ltd.), and pentaerythritol tetrapropanethiol.

One of these thiol compounds may be used singly, or two or more thereof may be used as a mixture.

Among them, pentaerythritol tetrapropanethiol is particularly preferred from the viewpoint of reactivity and storage stability.

The epoxy resin composition of the present embodiment preferably comprises, particularly, the epoxy resin (A), the curing agent particle (B) comprising the low-molecular amine compound (E) having a tertiary amino group and having a molecular weight of 1000 or smaller, and the thiol compound (F) from the viewpoint of reactivity in a low-temperature environment.

(Filler particle)

The epoxy resin composition of the present embodiment may optionally comprise an organic filler and/or an inorganic filler.

Examples of the organic filler include, but are not limited to, thermoplastic resins and thermoplastic elastomers, such as triblock copolymers, carbon fiber, cellulose, polyethylene powders, and polypropylene powders.

One of these organic fillers may be used singly, or two or more thereof may be used in combination.

Examples of the inorganic filler include, but are not limited to, fused silica, Crystalline silica, alumina, talc, silicon nitride, aluminum nitride, zinc oxide (ZnO), coal tar, glass fiber, asbestos fiber, boron fiber, quartz powders, mineral silicate, mica, asbestos powders, and slate powders.

One of these inorganic fillers may be used singly, or two or more thereof may be used in combination.

These organic fillers and inorganic fillers have a function of changing the viscoelasticity of the epoxy resin composition and attaining a proper viscosity, storage modulus, and thixotropy, and further tend to improve the fracture toughness of a cured product of the epoxy resin composition and reduce cure shrinkage.

The content of the filler particle in the epoxy resin composition of the present embodiment is preferably 10% by mass or more, more preferably 20% by mass or more, further preferably 25% by mass or more, from the viewpoint of sufficiently proper thixotropy and improvement in fracture toughness. The content of the filler particle in the epoxy resin composition of the present embodiment is preferably 85% by mass or less, more preferably 80% by mass or less, further preferably 75% by mass or less, from the viewpoint of a sufficiently low viscosity and excellent handling.

(Additive)

The epoxy resin composition of the present embodiment can optionally further comprise, in addition to the components mentioned above, additives such as an epoxy acrylic resin, a urethane acrylic resin, (meth)acrylic acid ester, a colorant, a silane coupling agent, an antioxidant, a photopolymerization initiator, a polymerization inhibitor, an antifoaming agent, a diluent, a reactive diluent, a flow adjuster, a thickener, a reinforcing agent, a mold release agent, a wetting agent, a flame retardant, a surfactant, and resins.

<Epoxy acrylic resin>

Examples of the epoxy resin that may be used as a starting material in producing the epoxy acrylic resin include, but are not limited to, bisphenol A-type epoxy resin, bisphenol F-type epoxy resin, bisphenol S-type epoxy resin, 2,2'-diallyl bisphenol A-type epoxy resin, hydrogenated bisphenol-type epoxy resin, propylene oxide-added bisphenol A-type epoxy resin, resorcinol-type epoxy resin, biphenyl-type epoxy resin, sulfide-type epoxy resin, diphenyl ether-type epoxy resin, dicyclopentadiene-type epoxy resin, naphthalene-type epoxy resin, phenol novolac-type epoxy resin, orthocresol novolac-type epoxy resin, dicyclopentadiene novolac-type epoxy resin, biphenyl novolac-type epoxy resin, naphthalene phenol novolac-type epoxy resin, glycidylamine-type epoxy resin, alkyl polyol-type epoxy resin, rubber-modified epoxy resin, glycidyl ester compounds, and bisphenol A-type episulfide resin.

Examples of a commercially available product of the epoxy acrylic resin include, but are not limited to, EA-1010, EA-1020, EA-5323, EA-5520, EA-CHD, and EMA-1020 (all manufactured by Shin-Nakamura Chemical Co., Ltd.), Ebecryl 860, Ebecryl 3200, Ebecryl 3201, Ebecryl 3412, Ebecryl 3600, Ebecryl 3700, Ebecryl 3701, Ebecryl 3702, Ebecryl 3703, Ebecryl 3800, Ebecryl 6040, and Ebecryl RDX63182 (all manufactured by Daicel-Cytec Co., Ltd.), Epoxy Ester M-600A, Epoxy Ester 40EM, Epoxy Ester 70PA, Epoxy Ester 200PA, Epoxy Ester 80MFA, Epoxy Ester 3002M, Epoxy Ester 3002A, Epoxy Ester 1600A, Epoxy Ester 3000M, Epoxy Ester 3000A, Epoxy Ester 200EA, and Epoxy Ester 400EA (all manufactured by Kyoei Kagaku Kogyo Co., Ltd.), and DENACOL Acrylate DA-141, DENACOL Acrylate DA-314, and DENACOL Acrylate DA-911 (all manufactured by Nagase ChemteX Corp.).

Only one of these epoxy acrylic resins may be used, or two or more thereof may be used in combination.

<Urethane acrylic resin>

The urethane acrylic resin is preferably aliphatic polyether urethane acrylate or acrylic acid ester and more preferably comprises a polyfunctional polyether (meth)acrylate oligomer. The polyether (meth)acrylate oligomer has at least one (meth)acrylate group, for example, one to four (meth)acrylate groups. The polyfunctional polyether (meth)acrylate oligomer is preferably a bifunctional aliphatic urethane acrylate oligomer. The polyfunctional urethane acrylate oligomer is prepared from, for example, aliphatic polyester or polyether polyol prepared by the condensation of dicarboxylic acid (e.g., adipic acid or maleic acid) and aliphatic diol (e.g., diethylene glycol or 1,6-hexanediol). In one aspect, the polyester polyol may comprise adipic acid and diethylene glycol. The polyfunctional isocyanate may comprise methylene dicyclohexyl isocyanate or 1,6-hexamethylene diisocyanate. The hydroxy-functionalized acrylate may comprise a hydroxyalkyl acrylate, for example, 2-hydroxyethyl acrylate, 2-hydroxypropyl acrylate, 4-hydroxybutyl acrylate, or polyethylene glycol acrylate. In one aspect, the polyfunctional urethane acrylate oligomer may comprise a reaction product of polyester polyol, methylene dicyclohexyl isocyanate, and hydroxyethyl acrylate.

Examples of the urethane acrylic resin specifically include BR-3042, BR-3641 AA, BR-3741 AB, and BR-344 from Bomar Specialties Co., CN-9002, CN-980, CN-981, and CN-9019 from Sartomer Companry Inc., Genomer 4188/EHA, Genomer 4269/M22, G enomer 4425, Genomer 1122, and Genomer 6043 from Rahn AG, and UV-3630ID80, UV-3630ID80, UV-N S054, and UV-NS077 manufactured by Nippon Soda Co., Ltd.

Preferred examples of the urethane acrylic resin also include bifunctional aliphatic polyester urethane acrylate oligomers and bifunctional aliphatic polyester/ether urethane acrylate oligomers.

Only one of these urethane acrylic resins may be used, or two or more thereof may be used in combination.

<(Meth)acrylic acid ester>

The (meth)acrylic acid ester may be monofunctional (meth)acrylic acid ester or may be polyfunctional (meth) acrylic acid ester.

Examples of the monofunctional (meth)acrylic acid ester include, but are not limited to, methyl methacrylate, ethyl methacrylate, n-propyl methacrylate, glycidyl methacrylate, 2-hydroxyethyl methacrylate, 2-isocyanatoethyl methacrylate, isobornyl methacrylate (e.g., product name "IBXA", Osaka Organic Chemical Industry Ltd.), 2-methacryloxyethyltrimethoxysilane, 2-methacryloxyethyltriethoxysilane, 3-methacryloxypropyltrimethoxysilane, 3-methacryloxypropylmethyldimethoxysilane, 3-methacryloxypropyltriethoxysilane, 3-methacryloxymethyldiethoxysilane, 4-methacryloxybutyltrimethoxysilane, 4-methacryloxybutyltriethoxysilane, dicyclopentenyloxyethyl methacrylate (e.g., product name "FA-512M", manufactured by Hitachi Chemical Co., Ltd.), dicyclopentanyl methacrylate (e.g., product name "FA513M", manufactured by Hitachi Chemical Co., Ltd.), pentamethylpiperidyl methacrylate (e.g., product name "FA-711MM", manufactured by Hitachi Chemical Co., Ltd.), tetramethylpiperidyl methacrylate (e.g., product name "FA-712HM", manufactured by Hitachi Chemical Co., Ltd.), methoxy polyethylene glycol methacrylate (e.g., manufactured by Hitachi Chemical Co., Ltd.), benzyl methacrylate (e.g., product name "FA-BZM", manufactured by Hitachi Chemical Co., Ltd.), 2-hydroxy-3-acryloyloxypropyl methacrylate (e.g., product name "Light Ester G-201P", manufactured by Kyoei Kagaku Kogyo Co., Ltd.), 2-methacryloyloxy ethyl phthalate (e.g., product name "CB-1", manufactured by Shin-Nakamura Chemical Co., Ltd.), methoxy polyethylene glycol methacrylate, phenoxyethylene glycol methacrylate (e.g., product name "PHE-1G", manufactured by Shin-Nakamura Chemical Co., Ltd.), stearyl methacrylate (e.g., product name "S", manufactured by Shin-Nakamura Chemical Co., Ltd.), 2-methacryloyloxyethyl succinate (e.g., product name "SA", manufactured by Shin-Nakamura Chemical Co., Ltd.), and 3,4-epoxycyclohexylmethyl methacrylate (e.g., product name "CYCLOMER M100", manufactured by Daicel Corp.).

Examples of the bifunctional (meth)acrylic acid ester include, but are not limited to, dipropylene glycol diacrylate (e.g., product name "APG-100, Shin-Nakamura Chemical Co., Ltd.), tricyclodecane dimethanol diacrylate (e.g., product name "A-DCP", Shin-Nakamura Chemical Co., Ltd.), 1,4-butanediol dimethacrylate (e.g., product name "FA-124M", manufactured by Hitachi Chemical Co., Ltd.), neopentyl glycol dimethacrylate (e.g., product name "FA-125M", manufactured by Hitachi Chemical Co., Ltd.), polyethylene glycol #200 dimethacrylate (e.g., product name "FA-220M", manufactured by Hitachi Chemical Co., Ltd.), EO-modified bisphenol A dimethacrylate (e.g., product name "FA-321M", manufactured by Hitachi Chemical Co., Ltd.), EO-modified polypropylene glycol #700 dimethacrylate (e.g., product name "FA-023M", manufactured by Hitachi Chemical Co., Ltd.), ethylene glycol dimethacrylate (e.g., product name "1G", manufactured by Shin-Nakamura Chemical Co., Ltd.), diethylene glycol dimethacrylate (e.g., product name "2G", manufactured by Shin-Nakamura Chemical Co., Ltd.), triethylene glycol dimethacrylate (e.g., product name "3G", manufactured by Shin-Nakamura Chemical Co., Ltd.), polyethylene glycol dimethacrylate (e.g., manufactured by Shin-Nakamura Chemical Co., Ltd.), 2,2-bis[4-(methacryloxyethoxy)phenyl]propane (e.g., product name "BPE-80N", manufactured by Shin-Nakamura Chemical Co., Ltd.), ethoxylated bisphenol A dimethacrylate (e.g., manufactured by Shin-Nakamura Chemical Co., Ltd.), tricyclodecane dimethanol dimethacrylate (e.g., product name "DCP", manufactured by Shin-Nakamura Chemical Co., Ltd.), 1,10-decanediol dimethacrylate (e.g., product name "DOD-N", manufactured by Shin-Nakamura Chemical Co., Ltd.), 1,6-hexanediol dimethacrylate (e.g., product name "HD-N", manufactured by Shin-Nakamura Chemical Co., Ltd.), 1,9-nonanediol dimethacrylate (e.g., product name "NOD-N", manufactured by Shin-Nakamura Chemical Co., Ltd.), neopentyl glycol dimethacrylate (e.g., product name "NPG", manufactured by Shin-Nakamura Chemical Co., Ltd.), ethoxylated polypropylene glycol dimethacrylate (e.g., manufactured by Shin-Nakamura Chemical Co., Ltd.), glycerin dimethacrylate (e.g., product name "701", manufactured by Shin-Nakamura Chemical Co., Ltd.), and polypropylene glycol dimethacrylate (e.g., manufactured by Shin-Nakamura Chemical Co., Ltd.).

Examples of the trifunctional or higher polyfunctional methacrylic acid ester include, but are not limited to, trimethylolpropane trimethacrylate (e.g., product name "TMPT", manufactured by Shin-Nakamura Chemical Co., Ltd.).

Only one of these (meth)acrylic acid esters may be used, or two or more thereof may be used in combination.

<Colorant>

Examples of the colorant include pigments and dyes.

The pigment contained can adjust the chromaticity of the epoxy resin composition of the present embodiment.

Examples of the pigment include, but are not limited to, carbon black, titanium black such as titanium nitride, black organic pigments, mixed color organic pigments, and inorganic pigments.

Examples of the black organic pigment include perylene black and aniline black. Examples of the mixed color organic pigment include pseudo-black pigments obtained by mixing at least two or more types of pigments selected from red, blue, green, purple, yellow, magenta, and cyan pigments. Examples of the inorganic pigment include fine particles of metals such as graphite, titanium, copper, iron, manganese, cobalt, chromium, nickel, zinc, calcium, and silver, metal oxide, composite oxide, metal sulfide, and metal nitride.

One of these pigments may be used singly, or two or more thereof may be used as a mixture.

The pigment is preferably carbon black or titanium black.

Examples of the dye include, but are not limited to, anthraquinone-based dyes, azo-based dyes, phthalocyanine-based dyes, quinacridone-based dyes, dioxazine-based dyes, anthrapyrimidine-based dyes, anthanthrone-based dyes, indanthrone-based dyes, flavanthrone-based dyes, pyranthrone-based dyes, perinone-based dyes, and thioindigo-based dyes.

<Silane coupling agent>

Examples of the silane coupling agent include, but are not limited to: tetraalkoxysilanes such as tetramethoxysilane, tetraethoxysilane, tetrapropoxysilane, tetraisopropoxysilane, tetrabutoxysilane, dimethoxydiethoxysilane, dimethoxydiisopropoxysilane, diethoxydiisopropoxysilane, and diethoxydibutoxysilane; trialkoxysilanes such as methyltrimethoxysilane, methyltriethoxysilane, methyltriisopropoxysilane, ethyltriethoxysilane, ethyltributoxysilane, cyclohexyltriethoxysilane, and phenyltriisopropoxysilane; and dialkoxysilanes such as dimethyldimethoxysilane, dimethyldiethoxysilane, diethyldiethoxysilane, diethyldibutoxysilane, and phenylethyldiethoxysilane.

One of these silane coupling agents may be used singly, or two or more thereof may be used in combination.

The amount of the silane coupling agent added is preferably 0.1 to 10 parts by mass, more preferably 0.5 to 5 parts by mass, per 100 parts by mass of the epoxy resin (A).

<Antioxidant>

Examples of the antioxidant include phenol-based antioxidants and hydroquinone-based antioxidants, and other antioxidants. A phenol-based antioxidant is preferred.

Examples of the phenol-based antioxidant include, but are not limited to, 2,2-methylene-bis(4-methyl-6-tertiary butylphenol), catechol, picric acid, tertiary butylcatechol, 2,6-di-tertiary butyl-p-cresol, and 4,4'-thiobis[ethylene(oxy) (carbonyl)(ethylene)]bis[2,6-bis(1,1-dimethylethyl)phenol].

Examples of the hydroquinone-based antioxidant include, but are not limited to, $\beta$-naphthoquinone, 2-methoxy-1,4-naphthoquinone, methylhydroquinone, hydroquinone, hydroquinone monomethyl ether, mono-tertiary butylhydroquinone, 2,5-di-tertiary butylhydroquinone, p-benzoquinone, 2,5-diphenyl-p-benzoquinone, and 2,5-di-tertiary butyl-p-benzoquinone.

Examples of other antioxidants include citric acid, phenothiazine, and 2-butyl-4-hydroxyanisole.

<Photopolymerization initiator>

The photopolymerization initiator is not particularly limited, and a photopolymerization initiator usually used in the art can be used.

Examples of a commercially available product of the photopolymerization initiator include, but are not limited to, IRGACURE 651 (2,2-dimethoxy-1,2-diphenylethan-1-one), IRGACURE 184 (1-hydroxy-cyclohexyl-phenyl-ketone), DAROCUR 1173 (2-hydroxy-2-methyl-1-phenyl-propan-1-one), IRGACURE 2959 (1-[4-(2-hydroxyethoxy)-phenyl]-2-hydroxy-2-methyl-1-propan-1-one), IRGACURE 127 (2-hydroxy-1-{4-[4-(2-hydroxy-2-methyl-propionyl)-benzyl]phenyl}-2-methyl-propan-1-one}, IRGACURE 907 (2-methyl-1-(4-methylthiophenyl)-2-morpholinopropan-1-one), IRGACURE 369 (2-benzyl-2-dimethylamino-1-(4-morpholinophenyl)-butanone-1), IRGACURE 379 (2-(dimethylamino)-2-[(4-methylphenyl)methyl]-1-[4-(4-morpholinyl)phenyl]-1-butanone), DAROCUR TPO (2,4,6-trimethylbenzoyl-diphenylphosphine oxide), IRGACURE 819 (bis(2,4,6-trimethylbenzoyl)-phenylphosphine oxide), IRGACURE 784 (bis($\eta$5-2,4-cyclopentadien-1-yl)-bis(2,6-difluoro-3-(1H-pyrrol-1-yl)-phenyl)titanium), IRGACURE OXE01 (1,2-octanedione,1-[4-(phenylthio)phenyl]-,2-(o-benzoyloxime)), IRGACURE OXE02 (ethanone, 1-[9-ethyl-6-(2-methylbenzoyl)-9H-carbazol-3-yl]-,1-(o-acetyloxime)), IRGACURE 754 (mixture of oxyphenylacetic acid,2-[2-oxo-2-phenylacetoxyethoxy]ethyl ester and oxyphenylacetic acid, 2-(2-hydroxyethoxy)ethyl ester), LucirinTPO, LR8893, and LR8970 (all manufactured by BASF Japan Ltd.), DETX-S (2,4-diethylthioxanthone) (manufactured by Nippon Kayaku Co., Ltd.), and Ubecryl P36 (manufactured by UCB S.A.).

Only one of these photopolymerization initiators may be used, or two or more thereof may be used in combination.

<Polymerization inhibitor>

Examples of the polymerization inhibitor include phenol-based polymerization inhibitors and phenothiazine-based polymerization inhibitors.

Examples of the phenol-based polymerization inhibitor include, but are not limited to, 2,2-methylene-bis(4-methyl-6-tertiary butylphenol)(BHT), catechol, picric acid, tertiary butylcatechol, 2,6-di-tertiary butyl-p-cresol, and 4,4'-thiobis[ethylene(oxy)(carbonyl)(ethylene)]bis[2,6-bis(1,1-dimethylethyl)phenol].

Examples of the phenothiazine-based polymerization inhibitor include, but are not limited to, phenothiazine, bis($\alpha$-methylbenzyl)phenothiazine, 3,7-dioctylphenothiazine, and bis($\alpha,\alpha$-dimethylbenzyl)phenothiazine.

[Method for producing epoxy resin composition]

The epoxy resin composition of the present embodiment can be obtained by mixing the component (A), the component (B), and optionally, the component (C), the component (D), the component (E), the component (F), and other additives mentioned above. A method for mixing the individual components is not particularly limited, and a general mixing facility and processing conditions are applied thereto. Examples thereof specifically include a method of thoroughly mixing the components until homogeneous using a mixing roll such as triple rolls, a dissolver, a planetary mixer, a kneader, an extruder, or the like to obtain an epoxy resin composition.

[Purpose]

The epoxy resin composition of the present embodiment and a cured product obtained therefrom can be used for various purposes in which epoxy resins are used as materials. The epoxy resin composition and the cured product are particularly useful for purposes such as an encapsulant (encapsulant formed from the cured product of the present embodiment), an encapsulant for a semiconductor, and an adhesive (adhesive comprising the epoxy resin composition of the present embodiment). The adhesive may be any of a thermosetting adhesive and a photocuring adhesive. The encapsulant and the adhesive obtained using the epoxy resin composition of the present embodiment or the cured product are useful for purposes of a camera module or a semiconductor package.

Among them, the epoxy resin composition and the cured product are suitably used in a composite material such as a dual curing (photocuring + thermal curing) adhesive aimed at precise immobilization.

Examples

Next, the present embodiment will be specifically described with reference to specific Examples and Comparative Examples. However, the present invention is not limited by Examples and Comparative Examples given below by any means.

In the following description, the terms "parts" and "%" are based on mass unless otherwise specified.

[Epoxy resin composition]

(Epoxy resins (A-1) to (A-3) and (C-1))

Epoxy resins (A-1) to (A-3) and (C-1) used in Examples and Comparative Examples mentioned later are shown in Table 1 below.

[Table 1]

| Epoxy resin No | Resin type | Epoxy equivalent (g/eq.) |
| --- | --- | --- |
| A-1 | Bisphenol A type | 185 |
| A-2 | Bisphenol F type | 170 |
| A-3 | Bisphenol A type | 190 |
| C-1 | Bisphenol A type | 195 |

(Amine compounds (D-1) to (D-9))

Amine compounds (D-1) to (D-9) used in the production of curing agent particles (B) used in Examples and Comparative Examples mentioned later are shown in Table 2 below.

[Table 2]

| Amine compound No | Amine type | Compound name |
|---|---|---|
| D-1 | Alicyclic amine compound | 1,3-Cyclohexanediamine _cis- and trans- mixture (manufactured by Tokyo Chemical Industry Co., Ltd.) |
| D-2 | Alicyclic amine compound | 1,4-Bis(aminomethyl)cyclohexane _cis- and trans- mixture (manufactured by Tokyo Chemical Industry Co., Ltd.) |
| D-3 | Alicyclic amine compound | 1,3-Bis(aminomethyl)cyclohexane _cis- and trans- mixture (manufactured by Tokyo Chemical Industry Co., Ltd.) |
| D-4 | Aromatic amine compound | m-Xylylenediamine (manufactured by Tokyo Chemical Industry Co., Ltd.) |
| D-5 | Aliphatic amine compound | Diethylenetriamine (manufactured by Tokyo Chemical Industry Co., Ltd.) |
| D-6 | Alicyclic amine compound | N,N-Dimethyl-1,4-cyclohexanediamine _cis- and trans-mixture (manufactured by Tokyo Chemical Industry Co., Ltd.) |
| D-7 | Aliphatic amine compound | N,N-Dimethylethylenediamine (manufactured by Tokyo Chemical Industry Co., Ltd.) |
| D-8 | Imidazole compound | 2-Methylimidazole (manufactured by Tokyo Chemical Industry Co., Ltd.) |
| D-9 | Aliphatic amine compound | Isophoronediamine (cis- and trans- mixture) (manufactured by Tokyo Chemical Industry Co., Ltd.) |

(Low-molecular amine compounds (E-1) and (E-2) having tertiary amino group)

Low-molecular amine compounds (E-1) and (E-2) having a tertiary amino group used in Examples and Comparative Examples mentioned later are shown in Table 3 below.

[Table 3]

| Low-molecular amine compound No having tertiary amino group | Compound name |
|---|---|
| E-1 | 1,4-Diazabicyclo[2.2.2]octane (manufactured by Tokyo Chemical Industry Co., Ltd.) |
| E-2 | (1,4-Diazabicyclo[2.2.2]octane-2-yl)methanol (manufactured by Tokyo Chemical Industry Co., Ltd.) |

(Curing agent particles (B-1) to (B-23))

Methods for determining physical properties and Production Examples will be shown below as to curing agent particles (B-1) to (B-23) used in Examples and Comparative Examples mentioned later.

<Methods for determining physical properties>

[Total amine value and tertiary amine value]

<Method for separating curing agent particle (B) in epoxy resin composition>

A method of mixing the epoxy resin composition with a specific solvent and precipitating the curing agent particles (B) using a centrifuge was used as a method for separating the curing agent particles (B) from the epoxy resin composition.
Specifically, 5.0 g of the specific solvent was added to and mixed with 5.0 g of the epoxy resin composition, and a supernatant was removed after centrifugation. 5.0 g of the same solvent as above was added again to precipitates to disperse the curing agent particles (B), followed by the removal of a supernatant after centrifugation. Further, cyclohexane was added to precipitates to disperse the curing agent particles (B), followed by the removal of a supernatant after centrifugation. The curing agent particles (B) were separated by vacuum drying at room temperature for 24 hours. The type of the solvent was selected from aromatic compounds of toluene, xylene, and trimethylbenzene as a solvent compatible with the epoxy resin and incapable of dissolving the curing agent particles (B).

If the separated curing agent particles (B) contained other particles, the curing agent (B) was separated by dissolving the curing agent particles (B) in a solvent capable of dissolving only the curing agent particles (B), filtering off other particles, and distilling off the solvent.

<Method for measuring total amine value>

The total amine value is the amount of potassium hydroxide indicated in mg equivalent to the amount of perchloric acid required for neutralizing all basic nitrogen atoms contained in 1 g of the curing agent particles, and this value was determined by the following procedures.

0.2 g of the curing agent particles was dissolved in 4.0 g of a 1:1 mixed solution of toluene and butanol. To 1.0 g of the obtained solution, 50.0 mL of acetic acid and 20 mL of acetone were added, and the mixture was stirred with a stirrer and titrated with a solution containing 0.1 mol of perchloric acid in acetic acid using a glass electrode and a comparative electrode.

The relationship between a read in a potentiometer or a pH meter and its corresponding titer of the 0.1 mol/L solution of perchloric acid in acetic acid was plotted, and an inflection point obtained in a titration curve was used as an endpoint.

The total amine value was calculated from the amount of the 0.1 mol/L solution of perchloric acid in acetic acid consumed.

<Measurement of tertiary amine value>

The tertiary amine value is the amount of potassium hydroxide indicated in mg equivalent to the amount of perchloric acid required for neutralizing nitrogen corresponding to tertiary amine contained in 1 g of the curing agent particles, and this value was determined by the following procedures.

0.5 g of the curing agent particles was dissolved in 4.0 g of a 1:1 mixed solution of toluene and butanol. To 1.0 g of the prepared solution, 10.0 mL of acetic acid and 10.0 mL of acetic anhydride were added, and the mixture was stirred and left standing for 30 minutes at room temperature to amidate a primary amino group and a secondary amino group. Then, the mixture was titrated with a solution containing 0.1 mol of perchloric acid in acetic acid using a glass electrode and a comparative electrode.

The relationship between a read in a potentiometer or a pH meter and its corresponding titer of the 0.1 mol/L solution of perchloric acid in acetic acid was plotted, and an inflection point obtained in a titration curve was used as an endpoint.

The tertiary amine value was calculated from the amount of the 0.1 mol/L solution of perchloric acid in acetic acid consumed.

[Particle size D50 and specific surface area value (Y) of curing agent particle (B)]

<Measurement of particle size D50 of curing agent particle (B)>

HORIBA LA-920 (particle size distribution analyzer HORIBA LA-920 manufactured by Horiba, Ltd.) was used as a particle size distribution measurement apparatus.

Specifically, 4 mg of a powder of the curing agent particles was precisely weighed, placed in 32 g of a solution containing 0.1% by mass of a surfactant (manufactured by Mitsui-Cytec Ltd., Aerosol OT-75) in cyclohexane, and dispersed by ultrasonic irradiation for 5 minutes with an ultrasonic cleaner (manufactured by **Honda Electronics** Co., Ltd., MODEL W-211). The internal water temperature of this ultrasonic cleaner was adjusted to 19 $\pm$ 2°C. A portion of the obtained dispersion was collected and subjected to particle size distribution measurement in HORIBA LA-920 (manufactured by Horiba, Ltd., particle size distribution analyzer HORIBA LA-920). The particle size D50 ($\mu$m) of the particles of interest was measured on the basis of the results.

<Measurement of specific surface area value of curing agent particle (B)>

The specific surface area value ($m^2/g$) of the curing agent particles was measured with a $N_2/He = 30/70$ (volume ratio) mixed gas as an adsorption gas using an automatic BET specific surface area measurement apparatus HM model-1201 manufactured by Mountech Co., Ltd.

[UV transmittance]

1.0 g of the curing agent particles was dissolved in 99.0 g of DMF to prepare a sample for UV measurement. A transmittance at a wavelength of 365 nm was calculated from an adsorption chart measured using an ultraviolet-visible-near infrared spectrophotometer V-660 (manufactured by JASCO Corp.). The optical path length of the cell used was 5 mm.

(Measurement conditions)

Measurement mode: abs

Scanning rate: 400 nm

Measurement wavelength: 300 nm to 800 nm

Reference solvent: DMF

<Production Example of curing agent particle (B-1)>

1 equivalent of the epoxy resin (C-1) and 2 equivalents of the amine compound (D-1) were reacted at 70°C in a 1:1 mixed solvent of n-butanol and toluene in a nitrogen atmosphere. Next, the internal temperature was elevated to 130°C, and the pressure was then reduced from the nitrogen atmosphere to 7.5 Torr. Then, the internal temperature was elevated to 180°C, and the solvent and an unreacted amine compound (D-1) were distilled off. The distillation was terminated when the amine compound (D-1) became 0.5% by mass, to obtain blocked curing agent 1 that was in a solid state at 25°C.
The obtained blocked curing agent 1 was roughly ground into approximately an average particle size on the order of 0.1 to 2 mm with a grinding machine "Rotoplex" (manufactured by Hosokawa Micron Corp.) to obtain a roughly ground product. The obtained roughly ground product was ground at a feed rate of 5.0 kg/Hr with an airflow jet mill (manufactured by Nisshin Engineering Inc., "CJ25 model") and classified with an air classifier (manufactured by Nisshin Engineering Inc., "Turbo Classifier") for the removal of coarse particles.
Then, the curing agent particles were heat-treated under conditions involving a feed rate of 2.0 kg/hr and a treatment temperature of 200°C using Meteorainbow-MR-10 manufactured by Nippon Pneumatic Mfg. Co., Ltd. to obtain curing agent particles (B-1) that were a solid at 25°C.
The content of the amine compound (D-1) in the obtained curing agent particles (B-1) was 0.5% by mass.
Physical properties are shown in Table 4 below.

<Production Example of curing agent particle (B-2)>

1 equivalent of the epoxy resin (C-1) and 1.5 equivalents of the amine compound (D-2) were reacted at 70°C in a 1:1 mixed solvent of n-butanol and toluene in a nitrogen atmosphere. Next, the internal temperature was elevated to 130°C, and the pressure was then reduced from the nitrogen atmosphere to 7.5 Torr. Then, the internal temperature was elevated to 180°C, and the solvent and an unreacted amine compound (D-2) were distilled off. The distillation was terminated when the amine compound (D-2) became 0.6% by mass. While the internal temperature was adjusted to 165°C in the nitrogen atmosphere, 18.0 g of the low-molecular amine compound (E-1) having a tertiary amino group was added to 82.0 g of the obtained reaction product, followed by stirring and mixing at the internal temperature of 165°C for 1 hour to obtain blocked curing agent 2 that was in a solid state at 25°C.
The obtained blocked curing agent 2 was roughly ground into approximately an average particle size on the order of 0.1 to 2 mm with a grinding machine "Rotoplex" (manufactured by Hosokawa Micron Corp.) to obtain a roughly ground product. The obtained roughly ground product was ground at a feed rate of 5.0 kg/Hr with an airflow jet mill (manufactured by Nisshin Engineering Inc., "CJ25 model") and classified with an air classifier (manufactured by Nisshin Engineering Inc., "Turbo Classifier") for the removal of coarse particles.
Then, the curing agent particles were heat-treated under conditions involving a feed rate of 2.0 kg/hr and a treatment temperature of 150°C using Meteorainbow-MR-10 manufactured by Nippon Pneumatic Mfg. Co., Ltd. to obtain curing agent particles (B-2) that were a solid at 25°C.
The content of the amine compound (D-2) in the obtained curing agent particles (B-2) was 0.5% by mass.

Other physical properties are shown in Table 4 below.

<Production Example of curing agent particle (B-3)>

Curing agent particles (B-3) were obtained in the same manner as in Production Example of the curing agent particles (B-2) except that the amine compound (D-2) was changed to the amine compound (D-3); and the low-molecular amine compound (E-1) having a tertiary amino group was changed to the low-molecular amine compound (E-2) having a tertiary amino group. Physical properties are shown in Table 4 below.

<Production Example of curing agent particle (B-4)>

Curing agent particles (B-4) were obtained in the same manner as in Production Example of the curing agent particles (B-1) except that the treatment using Meteorainbow-MR-10 manufactured by Nippon Pneumatic Mfg. Co., Ltd. was not carried out.
Physical properties are shown in Table 4 below.

<Production Example of curing agent particle (B-5)>

1 equivalent of the epoxy resin (C-1) and 2 equivalents of the amine compound (D-2) were reacted at 70°C in a 1:1 mixed solvent of n-butanol and toluene in a nitrogen atmosphere. Next, the internal temperature was elevated to 130°C, and the pressure was then reduced from the nitrogen atmosphere to 7.5 Torr. Then, the internal temperature was elevated to 180°C, and the solvent and an unreacted amine compound (D-2) were distilled off. The distillation was terminated when the amine compound (D-2) became 0.9% by mass, to obtain blocked curing agent 5 that was in a solid state at 25°C.
The obtained blocked curing agent 5 was roughly ground into approximately an average particle size on the order of 0.1 to 2 mm with a grinding machine "Rotoplex" (manufactured by Hosokawa Micron Corp.) to obtain a roughly ground product. The obtained roughly ground product was ground at a feed rate of 5.0 kg/Hr with an airflow jet mill (manufactured by Nisshin Engineering Inc., "CJ25 model") and classified with an air classifier (manufactured by Nisshin Engineering Inc., "Turbo Classifier") for the removal of coarse particles to obtain curing agent particles (B-5) that were a solid at 25°C.
The content of the amine compound (D-2) in the obtained curing agent particles (B-5) was 0.9% by mass.
Physical properties are shown in Table 4 below.

<Production Example of curing agent particle (B-6)>

1 equivalent of the epoxy resin (C-1) and 1.5 equivalents of the amine compound (D-3) were reacted at 70°C in a 1:1 mixed solvent of n-butanol and toluene in a nitrogen atmosphere. Next, the internal temperature was elevated to 130°C, and the pressure was then reduced from the nitrogen atmosphere to 7.5 Torr. Then, the internal temperature was elevated to 180°C, and the solvent and an unreacted amine compound (D-3) were distilled off. The distillation was terminated when the amine compound (D-3) became 2.3% by mass. While the internal temperature was adjusted to 165°C in the nitrogen atmosphere, 18.0 g of the low-molecular amine compound (E-1) having a tertiary amino group was added to 82.0 g of the obtained reaction product, followed by stirring and mixing at the internal temperature of 165°C for 1 hour with the nitrogen atmosphere maintained to obtain blocked curing agent 6 that was in a solid state at 25°C.
The obtained blocked curing agent 6 was roughly ground into approximately an average particle size on the order of 0.1 to 2 mm with a grinding machine "Rotoplex" (manufactured by Hosokawa Micron Corp.) to obtain a roughly ground product. The obtained roughly ground product was ground at a feed rate of 5.0 kg/Hr with an airflow jet mill (manufactured by Nisshin Engineering Inc., "CJ25 model") and classified with an air classifier (manufactured by Nisshin Engineering Inc., "Turbo Classifier") for the removal of coarse particles to obtain curing agent particles (B-6) that were a solid at 25°C.
The content of the amine compound (D-3) in the obtained curing agent particles (B-6) was 1.9% by mass.
Other physical properties are shown in Table 4 below.

<Production Example of curing agent particle (B-7)>

1 equivalent of the epoxy resin (C-1) and 1.5 equivalents of the amine compound (D-1) were reacted at 70°C in a 1:1 mixed solvent of n-butanol and toluene in a nitrogen atmosphere. Next, the internal temperature was elevated to 130°C, and the pressure was then reduced from the nitrogen atmosphere to 7.5 Torr. Then, the internal temperature was elevated to 180°C, and the solvent and an unreacted amine compound (D-1) were distilled off. The distillation was terminated when the amine compound (D-1) became 3.5% by mass. While the internal temperature was adjusted to 165°C in the nitrogen atmosphere, 18.0 g of the low-molecular amine compound (E-2) having a tertiary amino group was added to 82.0 g of the obtained reaction product, followed by stirring and mixing at the internal temperature of 165°C for 1 hour with the nitrogen atmosphere maintained to obtain blocked curing agent 7 that was in a solid state at 25°C.

The obtained blocked curing agent 7 was roughly ground into approximately an average particle size on the order of 0.1 to 2 mm with a grinding machine "Rotoplex" (manufactured by Hosokawa Micron Corp.) to obtain a roughly ground product. The obtained roughly ground product was ground at a feed rate of 5.0 kg/Hr with an airflow jet mill (manufactured by Nisshin Engineering Inc., "CJ25 model") and classified with an air classifier (manufactured by Nisshin Engineering Inc., "Turbo Classifier") for the removal of coarse particles to obtain curing agent particles (B-7) that were a solid at 25°C.

The content of the amine compound (D-1) in the obtained curing agent particles (B-7) was 2.9% by mass.

Other physical properties are shown in Table 4 below.

<Production Example of curing agent particle (B-8)>

1 equivalent of the epoxy resin (C-1) and 2 equivalents of the amine compound (D-2) were reacted at 70°C in a 1:1 mixed solvent of n-butanol and toluene in a nitrogen atmosphere. Next, the internal temperature was elevated to 130°C, and the pressure was then reduced from the nitrogen atmosphere to 7.5 Torr. Then, the internal temperature was elevated to 180°C, and the solvent and an unreacted amine compound (D-2) were distilled off. The distillation was terminated when the amine compound (D-2) became 3.1% by mass, to obtain blocked curing agent 8 that was in a solid state at 25°C.

The obtained blocked curing agent 8 was roughly ground into approximately an average particle size on the order of 0.1 to 2 mm with a grinding machine "Rotoplex" (manufactured by Hosokawa Micron Corp.) to obtain a roughly ground product. The obtained roughly ground product was ground at a feed rate of 5.0 kg/Hr with an airflow jet mill (manufactured by Nisshin Engineering Inc., "CJ25 model") and classified with an air classifier (manufactured by Nisshin Engineering Inc., "Turbo Classifier") for the removal of coarse particles to obtain curing agent particles (B-8) that were a solid at 25°C.

The content of the amine compound (D-2) in the obtained curing agent particles (B-8) was 3.1% by mass.

Physical properties are shown in Table 4 below.

<Production Example of curing agent particle (B-9)>

Curing agent particles (B-9) were obtained in the same manner as in Production Example of the curing agent particles (B-8) except that the amine compound (D-2) was changed to the amine compound (D-4).

Physical properties are shown in Table 4 below.

<Production Example of curing agent particle (B-10)>

1 equivalent of the epoxy resin (C-1) and 1.5 equivalents of the amine compound (D-4) were reacted at 70°C in a 1:1 mixed solvent of n-butanol and toluene in a nitrogen atmosphere. Next, the internal temperature was elevated to 130°C, and the pressure was then reduced from the nitrogen atmosphere to 7.5 Torr. Then, the internal temperature was elevated to 180°C, and the solvent and an unreacted amine compound (D-4) were distilled off. The distillation was terminated when the amine compound (D-4) became 3.8% by mass. While the internal temperature was heated to 165°C in the nitrogen atmosphere, 18.0 g of the low-molecular amine compound (E-2) having a tertiary amino group was added to 82.0 g of the obtained reaction product, followed by stirring and mixing at the internal temperature of 165°C for 1 hour with the nitrogen atmosphere maintained to obtain blocked curing agent 10 that was in a solid state at 25°C.

The obtained blocked curing agent 10 was roughly ground into approximately an average particle size on the order of 0.1 to 2 mm with a grinding machine "Rotoplex" (manufactured by Hosokawa Micron Corp.) to obtain a roughly ground product. The obtained roughly ground product was ground at a feed rate of 5.0 kg/Hr with an airflow jet mill (manufactured by Nisshin Engineering Inc., "CJ25 model") and classified with an air classifier (manufactured by Nisshin Engineering Inc., "Turbo Classifier") for the removal of coarse particles to obtain curing agent particles (B-10) that were a solid at 25°C.

The content of the amine compound (D-4) in the obtained curing agent particles (B-10) was 3.1% by mass.

Other physical properties are shown in Table 4 below.

<Production Example of curing agent particle (B-11)>

Curing agent particles (B-11) were obtained in the same manner as in Production Example of the curing agent particles (B-8) except that the amine compound (D-2) was changed to the amine compound (D-5).

Physical properties are shown in Table 4 below.

<Production Example of curing agent particle (B-12)>

Curing agent particles (B-12) were obtained in the same manner as in Production Example of the curing agent particles (B-8) except that the amine compound (D-2) was changed to the amine compound (D-6).

Physical properties are shown in Table 4 below.

<Production Example of curing agent particle (B-13)>

Curing agent particles (B-13) were obtained in the same manner as in Production Example of the curing agent particles (B-10) except that the amine compound (D-4) was changed to the amine compound (D-6).

Physical properties are shown in Table 4 below.

<Production Example of curing agent particle (B-14)>

Curing agent particles (B-14) were obtained in the same manner as in Production Example of the curing agent particles (B-8) except that the amine compound (D-2) was changed to the amine compound (D-7).

Physical properties are shown in Table 4 below.

<Production Example of curing agent particle (B-15)>

Curing agent particles (B-15) were obtained in the same manner as in Production Example of the curing agent particles (B-10) except that the amine compound (D-4) was changed to the amine compound (D-7).

Physical properties are shown in Table 4 below.

<Production Example of curing agent particle (B-16)>

Curing agent particles (B-16) were obtained in the same manner as in Production Example of the curing agent particles (B-8) except that 2 equivalents of the amine compound (D-2) were changed to 1 equivalent of the amine compound (D-8).

Physical properties are shown in Table 4 below.

<Production Example of curing agent particle (B-17)>

Curing agent particles (B-17) were obtained in the same manner as in Production Example of the curing agent particles (B-1) except that the amine compound (D-1) was changed to the amine compound (D-3).

Physical properties are shown in Table 4 below.

<Production Example of curing agent particle (B-18)>

Curing agent particles (B-18) were obtained in the same manner as in Production Example of the curing agent particles (B-1) except that 2 equivalents of the amine compound (D-1) were changed to 0.75 equivalents of the amine compound (D-3).

Physical properties are shown in Table 4 below.

<Production Example of curing agent particle (B-19)>

Curing agent particles (B-19) were obtained in the same manner as in Production Example of the curing agent particles (B-1) except that 2 equivalents of the amine compound (D-1) were changed to 0.7 equivalents of the amine compound (D-3).

Physical properties are shown in Table 4 below.

<Production Example of curing agent particle (B-20)>

1 equivalent of the epoxy resin (C-1) and 0.7 equivalents of the amine compound (D-9) were reacted at 70°C in a 1:1 mixed solvent of n-butanol and toluene. Next, the internal temperature was elevated to 180°C, and stirring was then continued for 1 hour. Then, the pressure was reduced from the air atmosphere to 7.5 Torr, and the solvent and an unreacted amine compound (D-9) were distilled off at the internal temperature of 180°C. The distillation was terminated when the amine compound (D-9) became 0.5% by mass, to obtain blocked curing agent 20 that was in a solid state at 25°C.

The obtained blocked curing agent 20 was roughly ground into approximately an average particle size on the order of 0.1 to 2 mm with a grinding machine "Rotoplex" (manufactured by Hosokawa Micron Corp.) to obtain a roughly ground product. The obtained roughly ground product was ground at a feed rate of 5.0 kg/Hr with an airflow jet mill (manufactured by Nisshin Engineering Inc., "CJ25 model") and classified with an air classifier (manufactured by Nisshin Engineering Inc., "Turbo Classifier") for the removal of coarse particles.

Then, the curing agent particles were heat-treated under conditions involving a feed rate of 2.0 kg/hr and a treatment temperature of 200°C using Meteorainbow-MR-10 manufactured by Nippon Pneumatic Mfg. Co., Ltd. to obtain curing agent particles (B-20) that were a solid at 25°C.

The content of the amine compound (D-9) in the obtained curing agent particles (B-20) was 0.5% by mass.

Physical properties are shown in Table 4 below.

<Production Example of curing agent particle (B-21)>

Curing agent particles (B-21) were obtained in the same manner as in Production Example of the curing agent particles (B-20) except that 0.7 equivalents of the amine compound (D-9) were changed to 0.75 equivalents of the amine compound (D-3).

Physical properties are shown in Table 4 below.

<Production Example of curing agent particle (B-22)>

Curing agent particles (B-22) were obtained in the same manner as in Production Example of the curing agent particles (B-20) except that 0.7 equivalents of the amine compound (D-9) were changed to 0.75 equivalents of the amine compound (D-3); and the mixing time at the internal temperature of 180°C was changed from 1 hour to 0.5 hours.

Physical properties are shown in Table 4 below.

<Production Example of curing agent particle (B-23)>

Curing agent particles (B-23) were obtained in the same manner as in Production Example of the curing agent particles (B-20) except that 0.7 equivalents of the amine compound (D-9) were changed to 0.75 equivalents of the amine compound (D-3); and the mixing time at the internal temperature of 180°C was changed from 1 hour to 0 hours.

Physical properties are shown in Table 4 below.

[Table 4]

| Curing agent particle No | Total amine value | Tertiary amine value | Particle size D50 (X) (μm) | Specific surface area value (Y) | Content of amine compound (D) (% by mass) | UV transmittance (%) |
|---|---|---|---|---|---|---|
| B-1 | 286 | 64 | 5.1 | 1.1 | 0.5 | 97 |
| B-2 | 298 | 195 | 5.0 | 1.1 | 0.5 | 94 |
| B-3 | 278 | 158 | 5.1 | 1.1 | 0.5 | 91 |
| B-4 | 286 | 64 | 5.0 | 2.0 | 0.5 | 97 |
| B-5 | 290 | 61 | 4.9 | 2.0 | 0.9 | 97 |
| B-6 | 306 | 193 | 5.1 | 2.1 | 1.9 | 94 |
| B-7 | 294 | 153 | 5.0 | 2.0 | 2.9 | 91 |
| B-8 | 319 | 59 | 5.1 | 1.9 | 3.1 | 97 |
| B-9 | 315 | 61 | 5.0 | 2.0 | 3.1 | 72 |
| B-10 | 311 | 154 | 4.9 | 1.9 | 3.1 | 65 |
| B-11 | 321 | 60 | 5.0 | 1.9 | 3.1 | 97 |
| B-12 | 178 | 117 | 4.9 | 1.9 | 3.1 | 97 |
| B-13 | 285 | 254 | 5.1 | 2.0 | 3.1 | 91 |
| B-14 | 180 | 118 | 5.0 | 1.9 | 3.1 | 97 |
| B-15 | 288 | 256 | 5.1 | 2.1 | 3.1 | 91 |
| B-16 | 155 | 155 | 5.1 | 1.9 | 3.1 | 31 |
| B-17 | 283 | 67 | 5.1 | 1.1 | 0.5 | 97 |

(continued)

| Curing agent particle No | Total amine value | Tertiary amine value | Particle size D50 (X) ($\mu$m) | Specific surface area value (Y) | Content of amine compound (D) (% by mass) | UV transmittance (%) |
|---|---|---|---|---|---|---|
| B-18 | 180 | 116 | 5.1 | 1.1 | 0.5 | 97 |
| B-19 | 163 | 105 | 5.1 | 1.1 | 0.5 | 97 |
| B-20 | 160 | 102 | 5.1 | 1.1 | 0.5 | 43 |
| B-21 | 184 | 119 | 5.1 | 1.1 | 0.5 | 45 |
| B-22 | 183 | 119 | 5.1 | 1.1 | 0.5 | 52 |
| B-23 | 188 | 122 | 5.1 | 1.1 | 0.5 | 71 |

(Thiol compounds (F-1) and (F-2))

Thiol compounds used in Examples and Comparative Examples mentioned later are shown in Table 5 below.

[Table 5]

| Thiol compound No | Compound name |
|---|---|
| F-1 | PEMP (tetrafunctional ester-type thiol) (manufactured by SC Organic Chemical Co., Ltd.) |
| F-2 | Multhiol Y4 (tetrafunctional ether-type thiol) (manufactured by SC Organic Chemical Co., Ltd.) |

[Preparation of epoxy resin composition]

<Example 1>

31.25 parts by mass of the epoxy resin (A-1), 31.25 parts by mass of the epoxy resin (A-2), 37.5 parts by mass of the curing agent particles (B-1), 1.0 part by mass of an encapsulating agent (manufactured by Nippon Polyurethane Industry Co., Ltd.; MR-200), and 0.5 parts by mass of distilled water were added, dispersed and mixed, and then reacted at 25°C to 45°C for 2 hours to obtain an epoxy resin composition (G-1) containing an encapsulated curing agent.
The obtained epoxy resin composition was used in evaluation given below.
The configuration of the epoxy resin composition is shown in Table 6 below. The obtained evaluation results are shown in Table 7 below.

<Examples 2 to 19, Examples 21 to 23, and Comparative Example 1>

Epoxy resin compositions (G-2) to (G-19), (G-21) to (G-22), and (G-26) to (G-27) were obtained in the same manner as in Example 1 except that the prescription was changed to those described in Table 6 below.
As in Example 1, the configuration of each epoxy resin composition is shown in Table 6 below. The obtained evaluation results are shown in Table 7 below.

<Example 20>

31.25 parts by mass of the epoxy resin (A-1), 31.25 parts by mass of the epoxy resin (A-2), and 37.5 parts by mass of the curing agent particles (B-6) were dispersed and mixed to obtain an epoxy resin composition (G-20).

<Comparative Example 2>

31.25 parts by mass of the epoxy resin (A-1), 31.25 parts by mass of the epoxy resin (A-2), and 37.5 parts by mass of the curing agent particles (B-16) were dispersed and mixed to obtain an epoxy resin composition (G-28).

[Evaluation]

<Adhesive strength>

Test pieces of the epoxy resin compositions (G-1) to (G-22) and (G-26) to (G-28) were prepared in accordance with JISK6850.

The adherend used was a 25 mm wide × 100 mm long × 1.6 mm thick adherend (cold-rolled copper plate) in accordance with JISC3141.

Each uncured test piece was placed in a small high-temperature chamber (ST-110B2, manufactured by ESPEC Corp.), the internal temperature of which was stable at 80°C, and heated for 1 hour. The test piece thus heated was left in a room-temperature environment and cooled to room temperature to obtain an adhesive strength measurement test piece.

An autograph tester (AGX-5kNX, manufactured by Shimadzu Corp.) was used with a load cell of 5 kN and at a rate of 5 mm/min to measure the maximum load where the adhesion surface of the test piece was ruptured so that the test piece was separated. A value obtained by dividing the maximum load at which the separation occurred by the adhesion area was used as adhesive strength.

A and B ranks were defined as accepted.

[Evaluation criteria]

A: The adhesive strength was 10.0 MPa or more.

B: The adhesive strength was 8.0 MPa or more and less than 10.0 MPa.

C: The adhesive strength was 6.0 MPa or more and less than 8.0 MPa.

D: The adhesive strength was less than 6.0 MPa.

<Degree of reduction in adhesive strength after storage in moist heat environment>

Each adhesive strength measurement test piece was prepared in the same manner as in the measurement of the adhesive strength described above. The test piece was stored in an environment having a temperature of 85°C and a humidity of 85%.

The test piece was taken out after 1 week from the start of storage and stored in an environment having a temperature of 25°C and a humidity of 50% for 1 day.

Then, the adhesive strength of the test piece was measured, and the degree (%) of reduction in adhesive strength was calculated according to the following expression (4).

Degree of reduction in adhesive strength (%) = {1 - (Adhesive strength after storage in the moist heat environment / Adhesive strength before storage in the moist heat environment)} × 100          Expression (4)

A and B ranks were defined as accepted.

[Evaluation criteria]

A: The degree of reduction in adhesive strength was less than 10.0%.

B: The degree of reduction in adhesive strength was 10.0% or more and less than 20.0%.

C: The degree of reduction in adhesive strength was 20.0% or more and less than 30.0%.

D: The degree of reduction in adhesive strength was 30.0% or more.

<Cured product Tg>

A 0.2 mm thick aluminum plate of 20 cm square was uniformly coated with each of the epoxy resin compositions (G-1) to (G-22) and (G-26) to (G-28) such that the thickness was 100 μm or longer and shorter than 300 μm. Then, the epoxy resin composition was cured by heating for 60 minutes in an oven of 80°C to obtain a cured product.

The obtained cured product was carefully peeled off and cut into a 5 mm wide × 25 mm long thin section of a cured product sample.

This cured product sample was used in measurement at a frequency of 1 Hz and a temperature increase rate of 2°C using a dynamic viscoelasticity measurement apparatus "RHEOVIBRON DDV-25FP" manufactured by Orientec Co., Ltd. on a tensile mode. The peak of tanδ was used as Tg of the epoxy resin compositions (G-1) to (G-22) and (G-26) to (G-28).

A to C ranks were defined as accepted.

[Evaluation criteria]

A: The cured product Tg was 90°C or higher.

B: The cured product Tg was 80°C or higher and lower than 90°C.

C: The cured product Tg was 70°C or higher and lower than 80°C.

D: The cured product Tg was lower than 70°C.

<Gel time>

The gel time of each of the epoxy resin compositions (G-1) to (G-22) and (G-26) to (G-28) was measured at a set temperature of 80°C using Curelastometer(R) (Curelastometer(R) V, manufactured by TS Press Engineering Co., Ltd.) to obtain a torque-vulcanization time chart. A point of 1 N·m and a point of 0.5 N·m were determined as to the obtained chart, and a time at which a straight line through these two points intersects with the vulcanization time axis was defined as a gel time. The value of the gel time was calculated.

A to C ranks were defined as accepted.

[Evaluation criteria]

A: The gel time was shorter than 4.0 minutes.

B: The gel time was 4.0 minutes or longer and shorter than 6.0 minutes.

C: The gel time was 6.0 minutes or longer and shorter than 8.0 minutes.

D: The gel time was 8.0 minutes or longer.

<Preservation stability (thickening ratio)>

The initial viscosity immediately after preparation of each of the epoxy resin compositions (G-1) to (G-22) and (G-26) to (G-28), and the viscosity of each of the epoxy resin compositions (G-1) to (G-22) and (G-26) to (G-28) left at 40°C for 7 days were measured at room temperature (25°C) using an E-type viscometer. The thickening ratio of the viscosities was calculated according to the following expression (5), and preservation stability was evaluated.

Thickening ratio = Viscosity after a lapse of 7 days for which the sample was left at 40°C / Initial viscosity ... Expression (5)

A and B ranks were defined as accepted.

[Evaluation criteria]

A: The thickening ratio was 1.0 time or more and less than 1.5 times.

B: The thickening ratio was 1.5 times or more and less than 2.0 times.

C: The thickening ratio was 2.0 times or more and less than 2.5 times.

D: The thickening ratio was 2.5 times or more.

<Viscosity measurement of epoxy resin composition>

The stage temperature of an E-type viscometer (TVE-35H, manufactured by Toki Sangyo Co., Ltd.) was adjusted to 25°C, and 0.2 g of each of the epoxy resin compositions (G-1) to (G-22) and (G-26) to (G-28) adjusted to 25°C in advance was placed on the stage, and the viscosity was measured.
A and B ranks were defined as accepted.

[Evaluation criteria]

A: The viscosity was less than 100 Pa·s.

B: The viscosity was 100 Pa·s or more and less than 300 Pa·s.

C: The viscosity was 300 Pa·s or more and less than 500 Pa·s.

D: The viscosity was 500 Pa·s or more.

<Case depth>

10 g of each of the epoxy resin compositions (G-1) to (G-22) and (G-26) to (G-28), 10 g of A-DCP (manufactured by Shin-Nakamura Chemical Co., Ltd.), and 0.6 g of a 50 wt% solution of 1-hydroxycyclohexyl phenyl ketone in MEK were placed in a plastic stirring container and mixed by stirring using a rotation/revolution mixer ("ARE-310" manufactured by Thinky Corp.) to prepare a sample for case depth measurement.
Next, a 3 mm thick silicon rubber sheet with a round hole of 15 mm in diameter was placed on a PET sheet of 10 cm square. The sample for case depth measurement was poured into the hole of the silicon rubber sheet to adjust the height of the sample to 3 mm.
The sample for case depth measurement poured into the silicon rubber sheet was irradiated with 365 nm-LED under conditions of 1000 mW/cm$^2$ × 2 seconds to cure the sample for case depth measurement.
Then, the cured sample was pulled out of the silicon rubber sheet, and the sample in an uncured portion was wiped off. Then, the height of the cured product was measured and used as a case depth.
A and B ranks were defined as accepted.

[Evaluation criteria]

A: The case depth was 2.0 mm or more.

B: The case depth was 1.5 mm or more and less than 2.0 mm.

C: The case depth was 1.0 mm or more and less than 1.5 mm.

D: The case depth was less than 1.0 mm.

<Residual calorific value measured with differential scanning calorimeter (DSC)>

The epoxy resin composition immediately after blending obtained in each of Examples and Comparative Examples was measured from 25 to 250°C at 10°C/min using a DSC measurement apparatus Q2000 manufactured by TA Instruments, and the obtained gross calorific value was defined as 100%. A cured product of the epoxy resin composition cured under conditions of 80°C for 1 hour was measured under the same conditions as above, and the percentage of the obtained gross calorific value was calculated and used as a residual calorific value (%).

<Crack resistance>

A 2 mm thick U-shaped Teflon(R) mold was sandwiched between two aluminum plates, and the epoxy resin composition of each of Examples and Comparative Example mentioned later was poured thereinto and held for 1 hour in an oven of 80°C to obtain a cured product.

The cured product was cut into a size of 2 mm × 4 mm × 20 mm.

The 2 mm × 20 mm surface was turned up, and a razor blade was put on the center of the side of 20 mm and in parallel with the side of 2 mm. A 1.8 to 2.2 mm crack was made in the cured product by hammering the razor blade from above. The distance between support points was set to 20 mm. The cracked surface was turned down, and a load was applied to the sample from above. The maximum point of test force, P, was measured.

The value of $K_{1c}$ was determined according to the mathematical expression (I) given below wherein a represents a crack length, W represents a test piece height, and B represents a test piece thickness.

In this contest, the unit of the test force P was MPa, and each of the units of the length a, W, and B was m.

$$f\left(\frac{a}{W}\right) = 3\sqrt{\frac{a}{W}} \cdot \frac{1.99 - \left(\frac{a}{W}\right)\left(1 - \frac{a}{W}\right)\left[2.15 - 3.93\frac{a}{W} + 2.7\left(\frac{a}{W}\right)^2\right]}{2\left(1 + 2\frac{a}{W}\right)\left(1 - \frac{a}{W}\right)^{\frac{3}{2}}}$$

$$K_{1c} = \frac{4WP}{BW^{\frac{3}{2}}} \cdot f\left(\frac{a}{W}\right) \qquad (\text{I})$$

The determined value of $K_{1c}$ was evaluated according to the criteria given below.

A and B ranks were defined as accepted.

[Evaluation criteria]

A: 1.5 or more

B: 1.2 or more and less than 1.5

C: 1.0 or more and less than 1.2

D: Less than 1.0

[Table 6]

| Epoxy resin composition No | Epoxy resin (A) | | | | Curing agent particle (B) | | Encapsulating agent | | Distilled water |
|---|---|---|---|---|---|---|---|---|---|
| | No. | parts | No. | parts | No. | parts | Type | 1 parts | parts |
| G-1 | A-1 | 31.25 | A-2 | 31.25 | B-1 | 37.5 | MR-200 | 1 | 0.5 |
| G-2 | A-1 | 31.25 | A-2 | 31.25 | B-2 | 37.5 | MR-200 | 1 | 0.5 |
| G-3 | A-1 | 31.25 | A-2 | 31.25 | B-3 | 37.5 | MR-200 | 1 | 0.5 |

(continued)

| Epoxy resin composition No | Epoxy resin (A) | | | | Curing agent particle (B) | | Encapsulating agent | | Distilled water |
|---|---|---|---|---|---|---|---|---|---|
| | No. | parts | No. | parts | No. | parts | Type | 1 parts | parts |
| G-4 | A-1 | 31.25 | A-2 | 31.25 | B-4 | 37.5 | MR-200 | 2 | 1.0 |
| G-5 | A-1 | 31.25 | A-2 | 31.25 | B-5 | 37.5 | MR-200 | 2 | 1.0 |
| G-6 | A-1 | 31.25 | A-2 | 31.25 | B-6 | 37.5 | MR-200 | 2 | 1.0 |
| G-7 | A-1 | 31.25 | A-2 | 31.25 | B-7 | 37.5 | MR-200 | 2 | 1.0 |
| G-8 | A-1 | 31.25 | A-2 | 31.25 | B-8 | 37.5 | MR-200 | 2 | 1.0 |
| G-9 | A-1 | 31.25 | A-2 | 31.25 | B-9 | 37.5 | MR-200 | 2 | 1.0 |
| G-10 | A-1 | 31.25 | A-2 | 31.25 | B-10 | 37.5 | MR-200 | 2 | 1.0 |
| G-11 | A-1 | 31.25 | A-2 | 31.25 | B-11 | 37.5 | MR-200 | 2 | 1.0 |
| G-12 | A-1 | 31.25 | A-2 | 31.25 | B-12 | 37.5 | MR-200 | 2 | 1.0 |
| G-13 | A-1 | 31.25 | A-2 | 31.25 | B-13 | 37.5 | MR-200 | 2 | 1.0 |
| G-14 | A-1 | 31.25 | A-2 | 31.25 | B-14 | 37.5 | MR-200 | 2 | 1.0 |
| G-15 | A-1 | 31.25 | A-2 | 31.25 | B-15 | 37.5 | MR-200 | 2 | 1.0 |
| G-16 | A-1 | 31.25 | A-2 | 31.25 | B-17 | 37.5 | MR-200 | 1 | 0.5 |
| G-17 | A-1 | 31.25 | A-2 | 31.25 | B-18 | 37.5 | MR-200 | 1 | 0.5 |
| G-18 | A-1 | 31.25 | A-2 | 31.25 | B-19 | 37.5 | MR-200 | 1 | 0.5 |
| G-19 | A-1 | 31.25 | A-2 | 31.25 | B-20 | 37.5 | MR-200 | 1 | 0.5 |
| G-20 | A-1 | 31.25 | A-2 | 31.25 | B-6 | 37.5 | - | - | - |
| G-21 | A-1 | 31.25 | A-2 | 31.25 | B-21 | 37.5 | MR-200 | 1 | 0.5 |
| G-22 | A-1 | 31.25 | A-2 | 31.25 | B-22 | 37.5 | MR-200 | 1 | 0.5 |
| G-26 | A-1 | 31.25 | A-2 | 31.25 | B-23 | 37.5 | MR-200 | 1 | 0.5 |
| G-27 | A-1 | 31.25 | A-2 | 31.25 | B-16 | 37.5 | MR-200 | 2 | 1.0 |
| G-28 | A-1 | 31.25 | A-2 | 31.25 | B-16 | 37.5 | - | - | - |

[Table 7]

| Example/Comparative Example | Epoxy resin composition | Adhesive strength (MPa) | Degree of reduction in adhesive strength (%) | Cured product Tg (°C) | Gel time (min) | Thickening ratio (times) | Viscosity (Pa·s) | Case depth (mm) | Residual calorific value (%) | Crack resistance |
|---|---|---|---|---|---|---|---|---|---|---|
| Example 1 | G-1 | A(12.5) | A(6.3) | A(104) | A(3.4) | A(1.0) | A(84) | A(2.3) | 0.0 | B |
| Example 2 | G-2 | A(10.4) | A(6.4) | A(92) | A(3.6) | A(1.0) | A(85) | A(2.3) | 0.0 | B |
| Example 3 | G-3 | A(10.8) | A(6.2) | A(91) | A(3.8) | A(1.0) | A(87) | A(2.1) | 0.0 | A |
| Example 4 | G-4 | A(12.5) | A(9.5) | A(104) | A(3.1) | A(1.3) | B(283) | A(2.3) | 2.8 | B |
| Example 5 | G-5 | A(12.5) | A(9.3) | A(104) | A(3.2) | A(1.5) | B(288) | A(2.3) | 3.2 | B |
| Example 6 | G-6 | A(10.5) | A(9.6) | A(95) | A(3.4) | B(1.7) | B(279) | A(2.3) | 3.1 | A |
| Example 7 | G-7 | A(10.9) | A(9.7) | A(96) | A(3.6) | B(1.9) | B(291) | A(2.1) | 3.3 | B |
| Example 8 | G-8 | A(12.9) | A(9.5) | A(106) | A(2.9) | C(2.1) | B(284) | A(2.3) | 2.9 | B |
| Example 9 | G-9 | A(11.7) | B(14.9) | A(115) | B(4.4) | C(2.1) | B(285) | B(1.6) | 7.4 | C |
| Example 10 | G-10 | A(10.1) | B(17.1) | A(115) | B(4.8) | C(2.2) | B(293) | C(1.3) | 9.1 | C |
| Example 11 | G-11 | A(11.1) | A(6.3) | C(78) | A(2.9) | C(2.1) | B(288) | A(2.3) | 0.0 | B |
| Example 12 | G-12 | B(9.3) | B(16.9) | B(84) | B(5.4) | C(2.2) | B(281) | A(2.3) | 8.4 | B |
| Example 13 | G-13 | B(8.2) | B(19.1) | C(77) | C(6.1) | C(2.1) | B(293) | A(2.1) | 9.6 | B |
| Example 14 | G-14 | B(9.0) | B(17.0) | B(80) | B(5.6) | C(2.2) | B(293) | A(2.3) | 8.8 | B |
| Example 15 | G-15 | B(8.1) | B(19.3) | C(72) | C(6.4) | C(2.1) | B(284) | A(2.1) | 9.8 | B |
| Example 16 | G-16 | A(14.1) | A(5.3) | A(103) | A(3.1) | A(1.0) | A(83) | A(2.3) | 0.0 | A |
| Example 17 | G-17 | B(9.4) | A(6.3) | C(72) | B(5.6) | A(1.0) | A(85) | A(2.3) | 9.2 | A |
| Example 18 | G-18 | B(8.8) | A(6.4) | C(72) | B(5.8) | A(1.0) | A(82) | A(2.3) | 9.3 | A |
| Example 19 | G-19 | B(8.1) | A(6.5) | C(70) | C(6.1) | A(1.0) | A(83) | D(0.8) | 9.6 | B |
| Example 20 | G-20 | A(10.2) | B(19.1) | B(88) | A(3.4) | D((Gelled) | A(84) | A(2.3) | 9.8 | B |
| Example 21 | G-21 | B(9.4) | A(6.3) | C(72) | B(5.6) | A(1.0) | A(85) | D(0.8) | 9.2 | A |
| Example 22 | G-22 | B(9.4) | A(6.3) | C(71) | B(5.4) | A(1.0) | A(83) | C(1.1) | 9.5 | A |
| Example 23 | G-26 | B(9.4) | A(6.3) | C(73) | B(5.4) | A(1.0) | A(84) | B(1.6) | 9.4 | A |

EP 4 782 475 A1

(continued)

| Example/Comparative Example | Epoxy resin composition | Adhesive strength (MPa) | Degree of reduction in adhesive strength (%) | Cured product Tg (°C) | Gel time (min) | Thickening ratio (times) | Viscosity (Pa·s) | Case depth (mm) | Residual calorific value (%) | Crack resistance |
|---|---|---|---|---|---|---|---|---|---|---|
| Comparative Example 1 | G-27 | D(2.4) | B(14.3) | D (Unevaluable) | D (Not gelled) | A(1.0) | B(279) | D(0.6) | 63.1 | D (Unevaluable) |
| Comparative Example 2 | G-28 | D(2.4) | D (Unevaluable) | D (Unevaluable) | D (Not gelled) | D((Gelled) | B(280) | D(0.6) | 66.4 | D (Unevaluable) |

<Example 24>

100 parts by mass of the epoxy resin (A-3), 65 parts by mass of the thiol compound (F-1), and 5 parts by mass of the epoxy resin composition (G-2) were stirred at 25°C for 5 minutes or longer to obtain an epoxy resin composition (G-23).
The obtained epoxy resin composition was used in evaluation given below.
The obtained results are shown in Table 8 below.

<Example 25>

100 parts by mass of the epoxy resin (A-3), 65 parts by mass of the thiol compound (F-2), and 5 parts by mass of the epoxy resin composition (G-3) were stirred at 25°C for 5 minutes or longer to obtain an epoxy resin composition (G-24).
The obtained epoxy resin composition was used in evaluation given below.
The obtained results are shown in Table 8 below.

<Comparative Example 3>

100 parts by mass of the epoxy resin (A-3), 65 parts by mass of the thiol compound (F-1), and 5 parts by mass of the epoxy resin composition (G-27) were stirred at 25°C for 5 minutes or longer to obtain an epoxy resin composition (G-25).
The obtained epoxy resin composition was used in evaluation given below.
The obtained results are shown in Table 8 below.

**[Evaluation]**

<Gel time>

The gel time of each of the epoxy resin compositions (G-23) to (G-25) was measured at a set temperature of 60°C using Curelastometer(R) (Curelastometer V, manufactured by TS Press Engineering Co., Ltd.) to obtain a torque-vulcanization time chart.
A point of 1 N·m and a point of 0.5 N·m were determined as to the obtained chart, and a time at which a straight line through these two points intersects with the vulcanization time axis was defined as a gel time. The value of the gel time was calculated.
A and B ranks were defined as accepted.

[Evaluation criteria]

A: The gel time was shorter than 6.0 minutes.

B: The gel time was 6.0 minutes or longer and shorter than 8.0 minutes.

C: The gel time was 8.0 minutes or longer and shorter than 10.0 minutes.

D: The gel time was 10.0 minutes or longer.

<Degree of reduction in adhesive strength after storage in moist heat environment>

Test pieces of the epoxy resin compositions (G-23) to (G-25) were prepared in accordance with JISK6850.
The adherend used was a 25 mm wide × 100 mm long × 1.6 mm thick adherend (cold-rolled copper plate) in accordance with JISC3141.
Each uncured test piece was placed in a small high-temperature chamber (ST-110B2, manufactured by ESPEC Corp.), the internal temperature of which was stable at 60°C, and heated for 30 minutes. The test piece thus heated was left in a room-temperature environment and cooled to room temperature to obtain an adhesive strength measurement test piece.
The test piece was stored in an environment having a temperature of 85°C and a humidity of 85%. The test piece was taken out after 1 week from the start of storage and stored in an environment having a temperature of 25°C and a humidity of 50% for 1 day. Then, the adhesive strength of the test piece was measured, and the degree (%) of reduction in adhesive strength was calculated according to the following expression (4).

Degree of reduction in adhesive strength (%) = {1 - (Adhesive strength after storage in the moist heat environment / Adhesive strength before storage in the moist heat environment)} $\times$ 100    Expression (4)

A and B ranks were defined as accepted.

[Evaluation criteria]

A: The degree of reduction in adhesive strength was less than 20.0%.

B: The degree of reduction in adhesive strength was 20.0% or more and less than 30.0%.

C: The degree of reduction in adhesive strength was 30.0% or more and less than 40.0%.

D: The degree of reduction in adhesive strength was less than 40.0%.

[Table 8]

| Example/Comp arative Example | Epoxy resin composition | Gel time (min) | Degree of reduction in adhesive strength (%) |
|---|---|---|---|
| Example 24 | G-23 | A(5.8) | A(9.4) |
| Example 25 | G-24 | A(5.4) | B(25.6) |
| Comparative Example 3 | G-25 | D(10.8) | C(33.6) |

The present application is based on the Japanese patent application filed with the Japan Patent Office on September 19, 2023 (Japanese Patent Application No. 2023-150966), the contents of which are incorporated herein by reference.

**Industrial Applicability**

The epoxy resin composition of the present invention has industrial applicability as a material for adhesives and encapsulants for various electronic components.

**Claims**

1. An epoxy resin composition comprising an epoxy resin (A) and a curing agent (B), wherein

    in the curing agent (B),
    when a value of a total amine value is defined as (a) and a value of a tertiary amine value is defined as (b), the values of (a) and (b) satisfy the following relational expression (1):

$$(a) - (b) \geq 5.0 \ ... \ (1).$$

2. The epoxy resin composition according to claim 1, wherein
a light transmittance measured at a wavelength of 365 nm by ultraviolet-visible spectroscopy of the curing agent (B) in the form of a solution of 1.0% by mass in dimethylformamide (DMF) is 50.0% or more.

3. The epoxy resin composition according to claim 1, wherein
a viscosity of the epoxy resin composition is 10.0 Pa·s or more and 800.0 Pa·s or less at 25°C.

4. The epoxy resin composition according to claim 1, wherein

the curing agent (B) comprises
at least one or more reaction products of an epoxy resin (C) and an amine compound (D).

5. The epoxy resin composition according to claim 4, wherein
the amine compound (D) is an aromatic amine compound or an alicyclic amine compound.

6. The epoxy resin composition according to claim 4, wherein
the amine compound (D) is an alicyclic amine compound.

7. The epoxy resin composition according to claim 1, wherein
the curing agent (B) is a curing agent particle.

8. An epoxy resin composition comprising an epoxy resin (A) and a curing agent particle (B-1), wherein

in the curing agent particle (B-1),
when a value of a total amine value is defined as (a) and a value of a tertiary amine value is defined as (b), the values of (a) and (b) satisfy the following relational expression (1):

$$(a) - (b) \geq 5.0 \ ... \ (1),$$

the curing agent particle (B-1) comprises
at least one or more reaction products of an epoxy resin (C) and an alicyclic amine compound (D), and
a light transmittance measured at a wavelength of 365 nm by ultraviolet-visible spectroscopy of the curing agent particle (B-1) in the form of a solution of 1.0% by mass in dimethylformamide (DMF) is 50.0% or more.

9. The epoxy resin composition according to claim 1, wherein
the curing agent (B) satisfies the following conditions (i) to (iii):

(i) being a curing agent particle,
(ii) a light transmittance measured at a wavelength of 365 nm by ultraviolet-visible spectroscopy in the form of a solution of 1.0% by mass in dimethylformamide (DMF) is 50.0% or more, and
(iii) comprising at least one or more reaction products of an epoxy resin (C) and an amine compound (D), wherein the amine compound (D) is alicyclic amine.

10. The epoxy resin composition according to claim 4, wherein
the amine compound (D) is 1,3-bis(aminomethyl)cyclohexane.

11. The epoxy resin composition according to claim 1, wherein
the curing agent (B) satisfies the following conditions (i), (ii), and (iv):

(i) being a curing agent particle,
(ii) a light transmittance measured at a wavelength of 365 nm by ultraviolet-visible spectroscopy in the form of a solution of 1.0% by mass in dimethylformamide (DMF) is 50.0% or more, and
(iv) comprising at least one or more reaction products of an epoxy resin (C) and an amine compound (D), wherein the amine compound (D) is 1,3-bis(aminomethyl)cyclohexane.

12. The epoxy resin composition according to claim 4, wherein
a content of the amine compound (D) in the curing agent (B) is 0.000001% by mass or more and 3.0% by mass or less.

13. The epoxy resin composition according to claim 7, wherein

when a specific surface area value of the curing agent (B) which is the curing agent particle is defined as (Y) ($m^2$/g) and its particle size D50 at an undersize cumulative fraction of 50% is defined as (X) ($\mu$m), the values of (X) and (Y) satisfy the following relational expression (2):

$$4.0(X)^{-1} \le (Y) \le 8.3(X)^{-1} \ ... \ (2).$$

**14.** The epoxy resin composition according to claim 1, wherein

a content of the curing agent (B) in the epoxy resin composition is
5.0% by mass or more and 65.0% by mass or less based on the total amount of the epoxy resin (A) and the curing agent (B).

**15.** The epoxy resin composition according to claim 7, wherein

the curing agent (B) which is the curing agent particle is
an encapsulated curing agent having a core particle surface-coated with a shell.

**16.** The epoxy resin composition according to claim 1, wherein
the curing agent (B) satisfies the following conditions (i), (ii), (iv), and (v):

(i) being a curing agent particle,
(ii) a light transmittance measured at a wavelength of 365 nm by ultraviolet-visible spectroscopy in the form of a solution of 1.0% by mass in dimethylformamide (DMF) is 50.0% or more,
(iv) comprising at least one or more reaction products of an epoxy resin (C) and an amine compound (D), wherein the amine compound (D) is 1,3-bis(aminomethyl)cyclohexane, and
(v) being an encapsulated curing agent having a core particle surface-coated with a shell.

**17.** The epoxy resin composition according to claim 1, wherein

when a gross calorific value measured with a differential scanning calorimeter (DSC) in the epoxy resin composition is defined as (c), and
a gross calorific value measured with a differential scanning calorimeter (DSC) in a cured product of the epoxy resin composition cured at 80°C for 60 minutes is defined as (d),
the values of (c) and (d) satisfy the following relational expression (3):

$$(d)/(c) \times 100 \le 20.0 ... \ (3).$$

**18.** The epoxy resin composition according to claim 1, wherein
the curing agent (B) comprises a low-molecular amine compound (E) having a tertiary amino group and having a molecular weight of 1000 or smaller.

**19.** The epoxy resin composition according to claim 18, wherein
the low-molecular amine compound (E) having a tertiary amino group is 1,4-diazabicyclo[2.2.2]octane or (1,4-diazabicyclo[2.2.2]octan-2-yl)methanol.

**20.** The epoxy resin composition according to claim 18, further comprising
a thiol compound (F).

**21.** An encapsulant comprising the epoxy resin composition according to any one of claims 1 to 20.

**22.** An adhesive comprising the epoxy resin composition according to any one of claims 1 to 20.

**23.** A camera module comprising the epoxy resin composition according to any one of claims 1 to 20.

**24.** A semiconductor package comprising the epoxy resin composition according to any one of claims 1 to 20.

**25.** Electronic equipment comprising the epoxy resin composition according to any one of claims 1 to 20.

# EP 4 782 475 A1

## INTERNATIONAL SEARCH REPORT

| | International application No. |
|---|---|
| | **PCT/JP2024/033116** |

### A. CLASSIFICATION OF SUBJECT MATTER

*C08G 59/40*(2006.01)i; *C08L 63/00*(2006.01)i; *C09J 11/06*(2006.01)i; *C09J 163/00*(2006.01)i; *H01L 23/29*(2006.01)i;
*H01L 23/31*(2006.01)i
FI: C08G59/40; C08L63/00 Z; H01L23/30 R; C09J163/00; C09J11/06

According to International Patent Classification (IPC) or to both national classification and IPC

### B. FIELDS SEARCHED

Minimum documentation searched (classification system followed by classification symbols)
C08G59/40; C08L63/00; C09J11/06; C09J163/00; H01L23/29; H01L23/31

Documentation searched other than minimum documentation to the extent that such documents are included in the fields searched
Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2004-269721 A (ASAHI KASEI CHEMICALS CORPORATION) 30 September 2004 (2004-09-30) claims 1, 3, paragraphs [0002], [0008], [0051], manufacturing example 2, example 2 | 1-12, 14-18, 21-25 |
| A | | 13, 19, 20 |
| X | JP 2021-38314 A (ASAHI KASEI CORPORATION) 11 March 2021 (2021-03-11) claims 1-7, paragraphs [0008], [0009], [0112], manufacturing examples 1-1, 1-2, 1-4, II-1, H-2, H-4 in table 1, examples 1-6, 9, 10 | 1-4, 7-8, 12-15, 17-25 |
| A | | 5-6, 9-11, 16 |
| X | WO 2017/179359 A1 (MITSUBISHI GAS CHEMICAL COMPANY, INC.) 19 October 2017 (2017-10-19) claims 1-6, 8, paragraphs [0010], [0011], [0038], [0041], examples 1-8, comparative examples | 1-6, 10, 12, 14, 17-19 |
| A | | 7-9, 11, 13, 15-16, 20-25 |

☑ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **06 November 2024** | **19 November 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

37

**EP 4 782 475 A1**

**INTERNATIONAL SEARCH REPORT**

International application No.

**PCT/JP2024/033116**

**C.    DOCUMENTS CONSIDERED TO BE RELEVANT**

| Category* | Citation of document, with indication, where appropriate, of the relevant passages | Relevant to claim No. |
|---|---|---|
| X | JP 57-42760 A (NITTO ELECTRIC INDUSTRIAL CO., LTD.) 10 March 1982 (1982-03-10) claims 1, 2, page 2, upper right column, second paragraph, table 1, example 1 | 1-2, 4-12, 14, 17 |
| A | | 3, 13, 15-16, 18-25 |
| X | JP 2007-224285 A (MITSUBISHI GAS CHEMICAL COMPANY, INC.) 06 September 2007 (2007-09-06) claims 1, 4, 7, 8, paragraph [0021], synthesis examples 1, 3, table 1 | 1-2, 4-6, 10, 12, 14, 17-19 |
| A | | 3, 7-9, 11, 13, 15-16, 20-25 |
| X | JP 2016-500744 A (DOW GLOBAL TECHNOLOGIES LLC) 14 January 2016 (2016-01-14) claims 1, 6-9, paragraphs [0065], [0096], table 1 | 1-2, 4-6, 10, 12, 14, 17 |
| A | | 3, 7-9, 11, 13, 15-16, 18-25 |
| A | JP 2015-113426 A (ASAHI KASEI E-MATERIALS CORPORATION) 22 June 2015 (2015-06-22) | 1-25 |

Form PCT/ISA/210 (second sheet) (July 2022)

38

**EP 4 782 475 A1**

**INTERNATIONAL SEARCH REPORT**
**Information on patent family members**

International application No.

**PCT/JP2024/033116**

| Patent document cited in search report | | | Publication date (day/month/year) | Patent family member(s) | | | Publication date (day/month/year) |
|---|---|---|---|---|---|---|---|
| JP | 2004-269721 | A | 30 September 2004 | (Family: none) | | | |
| JP | 2021-38314 | A | 11 March 2021 | (Family: none) | | | |
| WO | 2017/179359 | A1 | 19 October 2017 | CN | 108884211 | A | |
| | | | | TW | 201736427 | A | |
| JP | 57-42760 | A | 10 March 1982 | (Family: none) | | | |
| JP | 2007-224285 | A | 06 September 2007 | US claims 1, 4, 11, 13, paragraph [0049], synthesis examples 1, 3, table 1 | 2007/0179258 | A1 | |
| | | | | EP | 1813634 | A1 | |
| | | | | KR | 10-2007-0078703 | A | |
| | | | | TW | 200745194 | A | |
| JP | 2016-500744 | A | 14 January 2016 | US claims 1, 6-9, paragraphs [0068], [0115], table 1 | 2015/0240111 | A1 | |
| | | | | EP | 2912092 | A1 | |
| | | | | KR | 10-2015-0079622 | A | |
| | | | | CN | 104870513 | A | |
| JP | 2015-113426 | A | 22 June 2015 | (Family: none) | | | |

Form PCT/ISA/210 (patent family annex) (July 2022)

## EP 4 782 475 A1

**Patent documents cited in the description**

- JP 2006070125 A
- JP 2023150966 A